(19) Europäisches Patentamt
European Patent Office
Office européen des brevets

(11) EP 2 610 013 A1

(12) **EUROPEAN PATENT APPLICATION**
published in accordance with Art. 153(4) EPC

(43) Date of publication:
**03.07.2013 Bulletin 2013/27**

(21) Application number: **11819825.8**

(22) Date of filing: **16.08.2011**

(51) Int Cl.:
*B05D 3/06 (2006.01)* *B05D 5/00 (2006.01)*
*B32B 9/00 (2006.01)* *B65D 65/40 (2006.01)*
*H01L 51/50 (2006.01)* *H05B 33/02 (2006.01)*
*H05B 33/04 (2006.01)* *H05B 33/10 (2006.01)*

(86) International application number:
**PCT/JP2011/068556**

(87) International publication number:
**WO 2012/026362 (01.03.2012 Gazette 2012/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.08.2010 JP 2010188010**

(71) Applicant: **Konica Minolta Holdings, Inc.**
**Tokyo 100-7015 (JP)**

(72) Inventor: **TOYAMA Takahide**
**Hino-shi**
**Tokyo 191-8511 (JP)**

(74) Representative: **Henkel, Breuer & Partner**
**Patentanwälte**
**Maximiliansplatz 21**
**80333 München (DE)**

(54) **METHOD FOR MANUFACTURING GAS BARRIER FILM, AND ORGANIC PHOTOELECTRIC CONVERSION ELEMENT**

(57) The present invention provides: a method for manufacturing a gas barrier film, which is manufactured at high productivity, and has extremely high gas barrier performance and stability thereof with time, excellent surface smoothness and bending resistance, and high durability; a gas barrier film obtained using the method; and an organic photoelectric conversion element using the gas barrier film. In the method, after forming a coating film by applying a coating liquid containing polysilazane to a base material, a gas barrier layer is formed by applying vacuum-ultraviolet light to the coating film surface thus formed. The method is characterized in that the coating film is irradiated with the vacuum-ultraviolet light, while drying the solvent in the coating film.

FIG. 1a

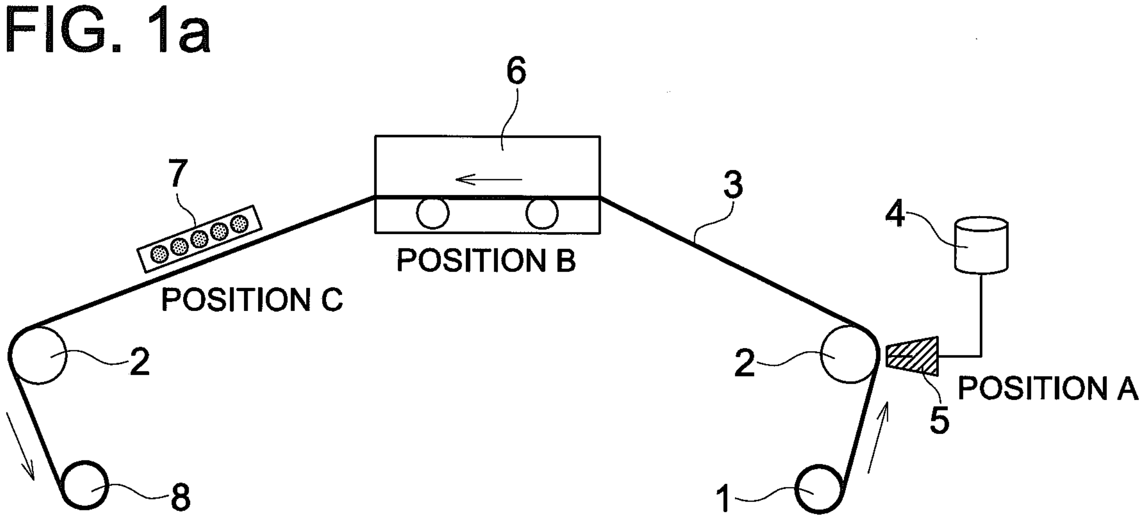


EP 2 610 013 A1

FIG. 1b

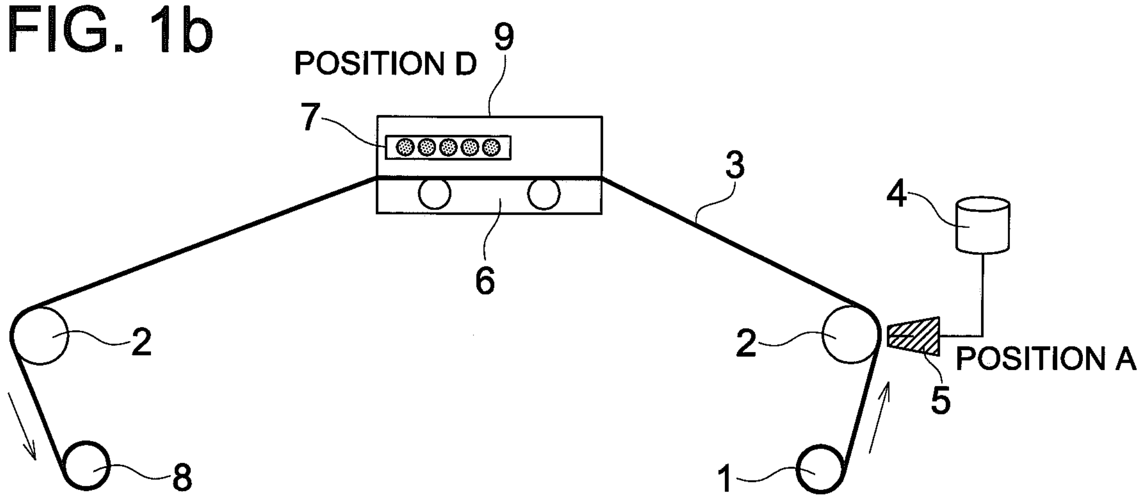

## Description

### FIELD OF THE INVENTION

The present invention relates to a manufacturing method of a gas barrier film which is mainly used for a package of an electronic device, or a material for an organic electroluminescent element, a solar cell or a plastic substrate of such as a liquid crystal display, and to an organic photoelectric conversion element employing the gas barrier film.

### BACK GROUND OF THE INVENTION

A barrier film in which a thin layer of a metal oxide such as aluminum oxide, magnesium oxide, or silicon oxide is formed on the surface of a plastic substrate or a film has been widely used for packaging a product which requires blocking of various types of gases such as water vapor and oxygen or for packaging to prevent a quality change of, for example, food, industrial products or medical products.

Also, aside from the use for packaging, barrier films have been used as a substrate for a liquid crystal display, a solar cell or an organic electroluminescent device (hereafter, also referred to as an organic EL device).

As a method to form such a gas barrier fihn, known has been a chemical deposition method (plasma CVD) by which a film is formed on a substrate using an organo silicon compound represented by TEOS (tetraethoxy silane) while it is oxidized by oxygen plasma under a reduced pressure, or a sputtering method by which metallic silicon is evaporated using a semiconductor laser and deposited on a substrate under existence of oxygen.

Since these methods enable to form a thin film having a precise composition on a substrate, these methods have been preferably used for forming a thin film of a metal oxide such as $SiO_2$. However, the productivity of these methods has been extremely low because a long time is needed to reduce the pressure and then open to air since the film formation is carried out under a reduced pressure, and because the apparatus becomes large.

In order to overcome the aforementioned problems and to improve the productivity, a method to form a thin film of silicon oxide by applying a silicon-containing compound, followed by modifying the applied layer, and an atmospheric pressure plasma CVD method in which, even though it is the same CVD method, plasma is generated under an atmospheric pressure to conduct film forming, have been tested.

Generally, as a method which enables to form a silicon oxide film via a wet process (namely, a wet applying method), a technique in which film is formed via a method so called as a sol-gel method, using an alkoxide as a raw material, has been known. This sol-gen method usually requires heating at a high temperature. Further, it has a problem that a considerable shrinkage occurs in the dehydration-condensation reaction process resulting in causing many defects in the film.

As a method to solve the above problem, a method to add an organic substance in the raw material solution, which does not directly take part in the formation of an oxide, has been examined. However, it has been afraid that the gas barrier property as a whole of the formed film may have been deteriorated due the organic substance remained in the film. Accordingly, it has been difficult to use the oxide film formed via a sol-gel method as it is as a protective film of a flexible electronic device.

As another method, a method to form a silicon oxide film using, as a raw material, silazane having a silazane structure (Si-N) as a basic structure has been proposed. Since the reaction, in this case, is a direct substitutional reaction from nitrogen to oxygen, but not a dehydration -condensation, the mass yield before and after the reaction is as large as from 80% to 100%, whereby a dense film having a smaller amount of defects in the film due to volume shrinkage can be obtained.

However, a high temperature atmosphere of 450 °C or more is required for the formation of a silicon oxide thin film via the substitutional reaction of a silazane compound. Accordingly, it has been difficult to apply this method to a flexible substrate such as plastic.

As a means to solve such a problem, proposed has been a method to form a silicon oxide film at a relatively lower temperature by conducting an oxidation reaction using reactive oxygen or ozone, while directly cutting the atomic bond in the silazane compound by an action of photon alone, which is called as a photon process, using photon energy of light of 100 nm to 200 nm, so called as vacuum ultraviolet light (hereafter, also referred to as VUV or VUV light), where the photon energy is larger than the atomic bond force in the silazane compound.

Disclosed has been a method in which a polysilazane film is formed via a wet coating method, followed by being irradiated with VUV light of a wavelength of 150 nm to 200 nm to modify the polysilazan fihn to a silicon oxide film, whereby a gas barrier film can be formed (refer to, for example, Patent Document 1).

Further disclosed has been a technique in which, in a similar way as disclosed in Patent Document 1, a polymer film having a silazane skeleton as a basic unit is formed by coating and the surface of the coated film is irradiated with vacuum ultraviolet light, and, then, a plurality of such films (two or more) are stacked, whereby an excellent barrier property can be obtained since the pores and defects formed on the substrate can be avoided and the obtained substrate

is free from causing cracks (refer to, for example, Patent Document 2).

However, the energy needed to form a silicon oxide film by being absorbed by the silazane compound tends to be lost since the substance existing between the vacuum ultraviolet light source and the polysilazane film, such as, oxygen gas existing in the space in the light pass, organic dust adhered on the surface of the polysilazane film, adsorbed water or oxygen atoms, or the solvent used for coating remained in the polysilazane film or on the surface also absorbs the vacuum ultraviolet light due to its high reactivity. However, the disturbance of efficient modification of the film due to the existence of impurity on the surface of the film after coating and drying has not been mentioned in the prior art. As the result, efficient achievement of excellent gas barrier property has not been attained.

## PRIOR ART DOCUMENTS

### PATENT DOCUMENTS

Patent Document 1: Japanese Patent Application Publication Open to Public Inspection (hereafter referred to as JP-A) No. 2009-503157
Patent Document 2: JP-A No. 2009-255040

## SUMMARY OF THE INVENTION

### PROBLEMS TO BE SOLVED BY THE INVENTION

The present invention was made in light of the above problems. An object of the present invention is to provide a method of manufacturing a gas barrier film exhibiting high productivity, an extremely high gas barrier property and its temporal stability, excellent surface lubricity and bending resistance, as well as high durability, and to provide an organic photoelectric conversion element employing the gas barrier film obtained by the method.

### MEANS TO SOLVE THE PROBLEMS

The above object of the present invention is achieved by the following structures.

1. A method of manufacturing a gas barrier film comprising the steps of:

   applying a coating liquid comprising polysilazane on a substrate to form a coated layer; and
   irradiating a coated layer side of the substrate with vacuum ultraviolet light to form a gas barrier layer, wherein the coated layer is irradiated with the vacuum ultraviolet light while drying a solvent contained in the coated layer.

2. The method of manufacturing the gas barrier film of Item 1, wherein the vacuum ultraviolet light is an irradiation light from a xenon excimer lamp.
3. The method of manufacturing the gas barrier film of Item 1 or 2, wherein an environment temperature when the coated layer is irradiated with the vacuum ultraviolet light is 70 °C or more, but 200 °C or less.
4. The method of manufacturing the gas barrier film of any one of Items 1 to 3, wherein the coated layer is irradiated with the vacuum ultraviolet light under a condition in which a residual amount of the solvent in the coated layer is 60% by mass or less, but 10% by mass or more.
5. An organic photoelectric conversion element comprising the gas barrier film manufactured by the method of manufacturing the gas barrier film of any one of Items 1 to 4.

### EFFECT OF THE INVENTION

According to the present invention, a method of manufacturing a gas barrier film exhibiting high productivity, an extremely high gas barrier property and its temporal stability, excellent surface lubricity and bending resistance, as well as high durability, and to provide an organic photoelectric conversion element employing the gas barrier film obtained by the method could be provided.

## BRIEF DESCRIPTION OF THE DRAWINGS

FIGS. 1a and 1b each illustrate a schematic flow diagram ofone example of a manufacturing line of a gas barrier film.
FIG. 2 is a cross-sectional view of one example of a solar cell having an organic photoelectric conversion element of a bulk heterojunction type.
FIG. 3 is a cross sectional view of a solar cell having an organic photoelectric conversion element containing a bulk heterojunction layer of a tandem type.
FIG. 4 is a cross sectional view of a solar cell having an organic photoelectric conversion element containing a bulk heterojunction layer of a tandem type.

## EMBODIMENTS TO CARRY OUT THE INVENTION

Embodiments to carry out the present invention will be described in detail below.

As the results of intensive examinations on the aforementioned problems, the present inventor has found that a method of manufacturing a gas barrier film exhibiting high productivity, an extremely high gas barrier property and its temporal stability, excellent surface lubricity and bending resistance, as well as high durability can be realized via a method of a gas barrier film characterized that, in a method of manufacturing a gas barrier film in which a gas barrier layer is formed by applying a coating liquid containing polysilazane on a substrate to form a coat film, followed by irradiating the side of the formed coat surface with vacuum ultraviolet light, the coat layer is irradiated with vacuum ultraviolet light while drying the solvent contained in the coat film. Thus the present invention was achieved.

Also, a gas barrier film manufactured by the method of manufacturing a gas barrier film of the present invention, and an organic photoelectric conversion element employing the gas barrier film could be provided.

Namely, the method of manufacturing a gas barrier film of the present invention is characterized that, after applying a coating liquid containing polysilazane on a substrate, the modification treatment that the coat film is irradiated with vacuum ultraviolet light is simultaneously conducted in the drying process.

In the usual method, namely, a coat film is formed on a substrate and a modification treatment is conducted after dried, problems that defects occur in the gas barrier layer due to the effect of an impurity, for example, adhered on the surface in the drying treatment, or that surface flatness is lost according to the unevenness caused in the modification treatment, have occurred.

Relating the above problems, a gas barrier layer exhibiting an extremely high gas barrier property can be obtained in the present invention by, in the drying process via heating, in which the solvent or the like is removed from the coated layer of polysilazane, to the surface active condition of the coated polysilazane layer, in which assist by the heat energy applied in the first half of the drying process still remains, immediately conducting a modification treatment by the irradiation of vacuum ultraviolet light in the latter half of the drying process, whereby the modification process (namely, the efficiency in silica transformation, or the reactivity of hydrolysis) is accelerated.

Further, a gas barrier layer exhibiting excellent uniformity and high flatness can be obtained because the modification treatment is conducted under a surface active condition, whereby the number of defects formed in the silica transformation process of the polysilazane layer initiated by the irradiation of vacuum ultraviolet light (namely, the oxidation reaction to cut the Si-N bond) is reduced.

The constituting elements and the manufacturing method of the gas barrier film of the present invention, and embodiments to carryout the present invention will be described below.

<<Manufacturing method of gas barrier film, and gas barrier film>>

The manufacturing method of the gas barrier film of the present invention, and the gas barrier film of the present invention manufactured by the method will be described.

The method of manufacturing the gas barrier film of the present invention is characterized as follows. The method of manufacturing the gas barrier film of the present invention contains: a coating step in which a coating liquid containing polysilazane is applied on the surface of a substrate to form a coated layer; a dying step in which the coated layer is dried; and a modification process in which the coated layer is modified to a gas barrier layer by irradiating the side of the coated surface formed on the substrate with vacuum ultraviolet light, wherein, the modification process in which the coated layer is irradiated with vacuum ultraviolet light is contained in the drying process.

[Manufacturing line of gas barrier film]

FIGs. 1a and 1b illustrate a schematic flow diagram of the manufacturing line of the gas barrier film.

FIG. 1a shows a conventional manufacturing line of a gas barrier film having mutually independent drying process and modification process.

A gas barrier film is manufactured according to the following method. In FIG. 1a, a polysilazane layer is formed as follows: Substrate 3 is taken out from roll 1 in which substrate 3 is stacked in a roll, and a polysilazane layer of a

prescribed thickness is formed by applying a polysilazane layer coating liquid supplied from polysilazane layer coating liquid tank 4 on substrate 3 at position A using coater 5. Subsequently, substrate 3 on which the polysilazane layer has been formed is dried in drying process 6 at position B, for example, by a drying wind of which temperature and moisture are controlled to remove the residual solvent in the coated layer. Then, in the modification process at position C which is on a further down stream side, the dried polysilazane layer is irradiated with, for example, VUV light from vacuum ultraviolet light irradiating device 7, whereby the polysilazane layer is modified to a gas barrier layer (a silicon oxide thin film), and, after that, the formed gas barrier film is stacked in winding roll 8 through a support roll 2. However, in the method as shown in FIG. 1a, in which the drying process at position B and he modification process at position C are separated, there have been varieties of aforementioned problems as a gas barrier film.

On the contrary, in the manufacturing line of the gas barrier film of the present invention shown in FIG. 1b, a vacuum ultraviolet light irradiating device is equipped in drying process 6 at position D. Accordingly, a gas barrier layer exhibiting high surface flatness while preventing generation of defects and an extremely high gas barrier property can be obtained by simultaneously irradiating the polysilazane layer with VUV light from vacuum ultraviolet light irradiating device 7 while drying the polysilazane layer.

In the present invention, it is specifically preferable that the formed coated layer is irradiated with vacuum ultraviolet light while the residual amount of the solvent in the coated layer formed on the substrate is 60% by mass or less, but 10% by mass or more.

In the present invention, the residual solvent amount (%) in the coated layer can be obtained as follows. First, the total amount of the solvent contained in the originally formed coated layer containing the polysilazane layer is determined (namely, calculated value: mass A, in which the residual solvent amount is 100%). Then, the coated layer is dried under a high temperature condition, and mass B is measured when the mass changing rate becomes 0 (in which residual solvent amount is 0%). Subsequently, mass A-mass B is designated as total mass C of the solvent component. Therefore, when the mass of the coated film dried at a prescribed condition is designated as D, the difference in mass of mass D - mass B (mass E) is the amount of the solvent at that time, and, thus, the residual solvent amount (%) can be obtained as {1 - (mass E / total mass C)} x 100%.

In the present invention, since the irradiation with vacuum ultraviolet light is conducted under a condition of the residual solvent amount of 10% by mass or more, a second drying process to complete drying the coated layer may also be provided.

The gas barrier layer so called in the present invention means a layer of a silicon oxide, such as silicon dioxide, formed by conducting a modification treatment on one or more polysilazane coated layers obtained by applying a polysilazane-containing liquid on a substrate. Also, in the present invention, the gas barrier property means that the moisture permeability (at 60 $\pm$ 0.5 °C, under a relative humidity of (90 $\pm$ 2)%RH) determined according to the method of JIS K 7129-1992 is 1 x $10^{-3}$ g/($m^2$•24h) or less, and that the the oxygen permeability determined according to the method of JIS K 7126-1987 is 1 x $10^{-3}$ ml/$m^2$•24h•atm or less.

[Substrate]

In the method of manufacturing a gas barrier film of the present invention, the substrate constituting the gas barrier film is not specifically limited as far as it is formed of an organic material which can support a gas barrier layer.

Examples of a substrate include: an acrylate ester, a methacrylate ester, polyethylene terephthalate (PET), poly butylene terephthalate, polyethylene naphthalate (PEN), polycarbonate (PC), polyarylate, polyvinyl chloride (PVC), polyethylene (PE), polypropylene (PP), polystyrene (PS), nylon (Ny), an aromatic polyamide, polyether ether ketone, polysulfone, poly ether sulfone, polyimide, poly ether imide, a heat-resistant transparent film (Sila-DEC, produced by CHISSO Corp.) and a substrate obtained by laminating two or more layers thereof. In view of the cost and ease of acquisition, for example, polyethylene terephthalate (PET), poly butylene terephthalate, polyethylene naphthalate (PEN) or polycarbonate (PC) is preferably used. Further, in view of optical transparency, heat resistance and adhesion with an inorganic layer, a heat resistant transparent film having a base moiety of silsesquioxane having an organic-inorganic hybrid structure may be preferably used. The thickness of the substrate is preferably 5 to 500 $\mu$m, and more preferably 20 to 250$\mu$m. The glass transition temperature (Tg) is preferably 100 °C or more. The thermal shrinkage ratio is preferably low.

The substrate according to the present invention is preferably transparent A transparent gas barrier film can be obtained by using a transparent substrate and by forming a transparent layer on the substrate. Thus, a transparent substrate for such as a solar cell or an organic photoelectric conversion element can be obtained.

The substrate using such as an aforementioned resin may be a non-stretched film or a stretched film.

The substrate used for the present invention may be manufactured by a conventionally well-known common method. For example, a non-stretched substrate (or support) which is substantially amorphous and non-oriented can be manufactured by melting a resin used as a material in an extruder, and extruding the melt from a ring die or a T-die, followed by quenching.

Further, a stretched substrate can be manufactured by stretching a substrate in a direction of the film flow (a longitudinal direction) or in a direction perpendicular to the direction of the film flow (a transverse direction) via a well-known method such as a uniaxial stretching method, a sequential biaxial stretching method using a tenter, a simultaneous biaxial stretching method using a tenter or a simultaneous biaxial stretching via a tubular method.
In this case, the stretching ratio may be arbitrarily selected in accordance with the type of the resin. However, the stretching ratio is preferably from twice to 10 times in each of the longitudinal direction and a transverse direction.
Further, when a stretched film is used as a substrate, it is preferable to conduct a relaxation treatment after stretching in order to improve the dimensional stability of the substrate.
Moreover, the substrate of the present invention may be subjected to a corona treatment.
When a commercially available film (such as PET) is used for the substrate, a film having an optional functional layer provided by the film maker may be used, for example, an adhesion enhancing layer. In this case, it is preferable because a process in which such an optional layer is additionally provided may be possibly abbreviated.

[Formation of polysilazane layer]

The polysilazane layer according to the present invention is formed by applying a coating liquid containing a polysilazane compound on a substrate.
An arbitrary wet coating method may be appropriately employed as a coating method. Examples of a wet coating method include a spin coat method, a roll coat method, a flow coat method, an inkjet method, a spray coat method, a printing method, a dip coat method, a casting film forming method, a bar coat method and a gravure printing method. The coating thickness may be arbitrarily determined according to the purpose. For example, the coating thickness may be selected so that the thickness after dried is preferably from 1 nm to 100 $\mu$m, more preferably from 10 nm to 10 $\mu$m, and the most preferably from 10 nm to 1 $\mu$m.
The "polysilazane" as used in the present invention is a polymer having a silicon-nitrogen bond, and is an inorganic ceramic precursor polymer such as $SiO_2$, $Si_3N_4$ and an intermediate solid solution thereof $SiO_xN_y$, containing, for example, Si-N, Si-H, N-H.
In view of coating without deteriorating the substrate, a compound having a constituting unit which can be transformed to a ceramic to form silica at a relatively low temperature such, as disclosed in JP-A No. 8-112879, is preferably used as a polysilazane to be used.

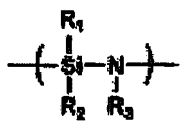

In the above formula, Ri, $R_2$ and $R_3$ each independently represent a hydrogen atom, an alkyl group, an alkenyl group, a cycloalkyl group, an aryl group, an alkylsilyl group, an alkylamino group or an alkoxy group.
In the present invention, perhydropolysilazane in which all of $R_1$, $R_2$ and $R_3$ represent a hydrogen atom is specifically preferable since a gas barrier layer exhibiting an excellent compactness can be obtained.
On the other hand, an organopolysilazane in which a part of the hydrogen bonded to Si is replaced with, for example, an alkyl group exhibits improved adhesion to a substrate which is a subbing layer. Also, such an organicpolysilazane provides stiffness to the ceramic layer of polysilazane, which is hard and brittle, whereby a merit to prevent cracking even when the (average) layer thickness becomes larger can be acquired. These perhydropolysilazane and organopolysilazane may be arbitrarily selected according to the use, or may be used in combination.
Perhydropolysilazane is assumed to have a structure containing a linear structure and 6- and 8-membered ring structure. Its molecular weight is around 600 to 2000 (in polystyrene conversion) in terms of a number average molecular weight (Mn), and it has both solid state and liquid state depending on the molecular weight. These compounds are commertially available as a solution by being dissolved in an organic solvent The commercially available product can be used as a polysilazane-containing coating liquid as it is.
Other examples of a polysilazane which can be tansformed into a ceramic at a lower temperature include: a silicon alkoxide adduct of polysilazane obtained by reacting a silicon alkoxide with a polysilazane described in above exemplidied JP-A No. 8-112879 (refer to JP-A No. 5-238827); a glycidol adduct of polysilazane obtained by reacting a glycidol with a polysilazane (refer to JP-A No. 6-122852); an alcohol adduct of polysilazane obtained by reacting an alcohol with a polysilazane (refer to JP-A No. 6-240208); an metal carboxylate adduct of polysilazane obtained by reacting a metal carboxylate with a polysilazane (refer to JP-A No. 6-299118); an acetylacetonate adduct of polysilazane obtained by reacting an acetylacetonate complex containing a metal with a polysilazane (refer to JP-A No. 6-306329); and a metallic particle addition polysilazane obtained by adding metallic particles to a polysilazane (refer to JP-A No. 7-196986).

As an organic solvent used to prepare a coating liquid containing a polysilazane, an alcohol solvent or a water-containing solvent which easily react with a polysilazane is preferably avoided to use. Examples of a specifically usable organic solvent include: hydrocarbon solvents such as an alophatic hydrocarbon, an alicyclic hydrocarbon and an aromatic hydrocarbon; a halogen-containing hydrocarbon solvent; and ethers such as an aliphatic ether and an alicyclic ether. Concrete examples thereof include: hydrocarbons such as pentane, hexane, cyclohexane, toluene, xylene, solvesso and terpentine; halogen-containinghydrocarbons such as methylene chloride and trichloroethane; and ethers such as dibutyl ether, dioxane and tetrahydrofuran. These organic solvents may be chosen according to, for example, the solubility of polysilazane or the vaporizing rate of a solvent. These solvent may be used in combination of a plurality of solvents.

The polysilazane concentration in the coating liquid containing a polysilazane may be different depending on the aimed layer thickness of the silica membrane or a pot life of the coating liquid, however, the polysilazane concentration is within around 0.2 to 35% by mass.

The organic polysilazane may be a derivative in which a part of hydrogen portion combined with Si is replaced with an alkyl group. By having an alkyl group, specifically, a methyl group having the smallest molecular weight, the adhesive property with the substrate is improved, and toughness can be given to hard and brittle silica membrane, whereby it is preferable because cracking can be prevented even when the layer thickness becomes larger.

In order to promote the conversion to a silicon oxide compound, a catalyst such as amine or a metal can also be added. Concrete examples of such a catalyst include AQUAMICA NAX 120-20, NN 110, NN 310, NN 320, NL 110A, NL 120A, NL 150A, NP 110, NP 140 and SP 140, each produced by AZ ELECTRONIC MATERIALS.

[Drying process]

In the method of manufacturing a gas barrier film of the present invention according to the aforementioned method, a coating liquid containing polysilazane and an organic solvent is applied on a substrate to form a polysilazane layer, followed by removing the organic solvent and the like in the drying process. The present invention is characterized that, simultaneously in the drying process, a modification treatment is conducted, in which the polysilazane layer is irradiated with the later mentioned vacuum ultraviolet light.

The drying process carried out simultaneously with the modification process is a process of which purpose is to remove the organic solvent contained in the coated layer ofpolysilazane. In the drying process, the drying condition to remove mainly an organic solvent can be appropriately selected, for example, a heat treatment, and the drying condition may be one which is also suitable for removing water. The heat treatment temperature is preferably high in view of quick treatment, however, the temperature and the treatment time may be arbitrarily determined while considering the heat damage to the resin substrate. The heat treatment temperature is preferably 70 °C or more, but 200 °C or less. For example, when a polyethylene terephthalate substrate having a glass transition temperature of 70 °C is used, the heat treatment temperature may be set at 200 °C or less. The treatment time is preferably set shorter to remove the solvent and to reduce the heat damage to the substrate. When the heat treatment temperature is 200 °C or less, the treatment time may be 30 minutes or shorter.

In the method of manufacturing a gas barrier film of the present invention, a dehydration process to remove water may be provided subsequently to the aforementioned drying process, if necessary. The dehydration process is a process of which purpose is to remove the organic solvent, and to remove water from the gas barrier layer (namely, a silicon oxide layer) obtained via the modification process.

The dehydration process is a process for removing water in the formed gas barrier layer. As a method to remove water, cited is an embodiment in which the gas barrier layer is kept under a low humidity condition, as a first method. Since the humidity under a low humidity condition changes depending on the temperature, a preferable condition with respect to the relationship between the temperature and the humidity can be obtained by prescribing a dew point temperature. The preferable dew point temperature is 4 °C or less (temperature: 25 °C /humidity: 25%), more preferably -8 °C or less (temperature: 25 °C / humidity: 10%), and still more preferably -31 °C or less (temperature: 25 °C /humidity: 1%). As a second method, cited is an embodiment in which the gas barrier layer is kept under a reduced pressure condition. Specifically, preferable is a pressure condition of lower than the normal pressure (1 atm), concretely, 0.4 atm or less to obtain an effect, preferably 0.1 atm or less and more preferably 0.01 atm or less.

[Modification process ofpolysilazane layer]

In the method of manufacturing a gas barrier film of the present invention, a polysilazane layer which is wet is subjected to a modification treatment in which the polysilazane layer is irradiated with vacuum ultraviolet light (VUV) to modify the polysilazane layer to a gas barrier layer, simultaneously with drying the polysilazane layer formed by using a coating liquid containing a polysilazane and a solvent

Having a modification process in which the polysilazane layer is irradiated with vacuum ultraviolet light (VUV)

within the drying process, or conducting a modification treatment in which the polysilazane layer is irradiated with vacuum ultraviolet light (VUV) within the drying process, as mentioned in the present invention, means to conduct a modification treatment in which the polysilazane layer is irradiated with vacuum ultraviolet light (VUV) in the period from when the drying process is started by blowing the substrate having thereon a wet polysilazane layer with a hot wind heated at a prescribed temperature, to when the residual amount of the solvent becomes 5% by mass or less by removing the organic solvent contained in the polysilazane layer. It is preferable, in view of effectively acquiring the leveling effect due to the residual solvent, that the modification process is conducted while the degree of drying of the polysilazane layer is from 40% or more to 90% or less, in other word, while the residual solvent amount is from 60% or less to 10% or more.

The gas barrier layer according to the present invention is obtained by applying a coating liquid containing a polysilazane on a substrate, followed by irradiating the obtained polysilazane layer with vacuum ultraviolet light (VUV) to conduct a modification treatment.

According to the vacuum ultraviolet light irradiation, the substrate is heated, and $O_2$ and $H_2O$ which contribute the ceramics transformation (silica transformation), an ultraviolet light absorber and the polysilazane itself are excited, whereby the ceramics transformation of the polysilazane is promoted and the obtained ceramic film becomes denser. The irradiation with vacuum ultraviolet light is effective at any time, if it is after the formation of a coated layer.

In general, "ultraviolet light" means, concretely, ultraviolet light (UV light) having a wavelength of 400 nm or less, and radiation containing X rays and electron beam. However, in the present invention, concretely, ultraviolet light (VUV light) of from 100 nm to 200 nm is preferably used.

The irradiation intensity and/or irradiation time of the vacuum ultraviolet light are detenmined not to damage the substrate which carryies the coated film to be irradiated For example, when a plastic film is used as a substrate, it is preferable that the substrate-lamp distance is set so that the intensity at the substrate surface is from 10 mW/cm$^2$ to 300 mW/cm$^2$, and the irradiation is conducted within 0.1 sec to 10 minutes, more preferably 0.5 sec to 3 minutes.

In the present invention, the environmental temperature at the vacuum ultraviolet light irradiation is preferably 70 °C or more but 200 °C or less.

A commercially available lamp (for example, produced by USHIO Inc.) may be used as a vacuum ultraviolet light emitting apparatus.

The vacuum ultraviolet light (VUV) irradiation can be suitably applied for both a batch treatment and a continuous treatment, and can be suitably selected according to the shape of the substrate to be coated.

For example, in the case of a batch treatment, a substrate (for example, a silicon wafer) which has a layer of polysilazane coat on the surface can be treated in a vacuum ultraviolet light calcination furnace equipped with a vacuum ultraviolet light source. A vacuum ultraviolet light calcination furnace itself is commonly known and, for example, one produced by USHIO Inc. may be used. When the substrate which has polysilazane coat on the surface is a long length film, conversion to a ceramic can be conducted by being continuously irradiated with vacuum ultraviolet light in a drying zone equipped with a vacuum ultraviolet light source as described above while the substrate is conveyed.

Vacuum ultraviolet light has energy larger than the force of atomic bond of most of the materials. Accordingly, it can be preferably used since the atomic bond can be directly cut due to an action only by a photon, which is called as a "light quantum process". By employing this action, a conversion treatment can be effectively carried out at a low temperature without conducting hydrolysis.

A rare gas excimer lamp using excimer luminescence as a source of vacuum ultraviolet light is preferably used.

Regarding excimer luminescence, rare gas atoms, such as Xe, Kr, Ar, and Ne, are called an inert gas since they do not combine chemically to make a molecule. However, the rare gas atom acquired energy by electric discharge (excitation atom) can combine with other atoms to make a molecule. When the rare gas atom is xenon, the following reaction will occur.

$$e + Xe \rightarrow Xe^*$$

$$Xe^* + 2Xe \rightarrow Xe_2^* + Xe$$

$$Xe_2^* \rightarrow Xe + Xe + h\nu \text{ (172 nm)}$$

During the time, the excited excimer molecule $Xe_2^*$ transits to a ground state, an excimer light of 172 nm will be emitted. As a distinctive feature of an excimer lamp, since radiation concentrates on one wavelength and other lights except a required light are emitted, it is cited that efficiency is high.

Moreover, since an excessive light is not emitted, the temperature of a subject can be kept low. Further, since there is not required time for starting and re-starting, immediate lighting and extinguish are possible.

A method of using dielectric barrier discharge for obtaining excimer luminescence is known. The dielectric barrier discharge is a thin discharge similar to thunder and called as a micro discharge, which is generated in the gas space by applying a high frequency voltage of several tens kHz between both electrodes while providing a gas space

via a dielectric (a transparent quartz in the case of an excimer lamp), and the micro discharge vanishes when the streamer of the micro discharge reaches at the tube wall (a dielectric) because charge is accumulated on the dielectric surface.

This micro discharge is the discharge which spreads over the whole of the tube wall, by which the generation and the disappearance of discharge are repeated. For this reason, flickering of light occurs, which can be observed even with the naked eyes. Since a streamer having a very high temperature locally reaches the tube wall directly, there may be a possibility to accelerate the degradation of the tube wall.

As a method of obtaining excimer luminescence efficiently, discharge by non-electrode electric field is also possible in addition to dielectric barrier discharge.

The discharge by non-electrode electric field is done by capacity bonding, and it is also called as RF discharge. Although the used lamp and electrodes and their arrangement are basically the same as those for the dielectric barrier discharge, the high frequency wavelength impressed to the electrodes is several MHz. Since spatially and temporally uniform discharge can be obtained with discharge by non-electrode electric field, it can obtain a lamp without flicker and long lifetime.

In the case of the dielectric barrier discharge, micro discharge is taken place only between the electrodes. Therefore, in order to discharge in the whole discharge space, the outer electrode has to be covered the whole outer surface and, at the same time, it has to be transparent so as to take out light to the outside.

For this purpose, it is used an electrode made of a fine metal wire mesh. Since this electrode is made of a metal wire as fine as possible in order to avoid shielding of light, this electrode is easy to be damaged with ozone generated by vacuum ultraviolet light under an oxygen environment

In order to prevent this, it is necessary to make the circumference of a lamp, i.e., the inside of the irradiation equipment, into an inert gas atmosphere, such as nitrogen, and to prepare a window of synthetic quartz, and to take out illuminating radiation. The window of synthetic quartz is not only expensive expendables, but also produce the loss of light

A double cylinder type lamp has an outside diameter of about 25 mm, therefore, it cannot disregard the difference of the distance between the directly underside of the lam shaft and the lamp exposure lateral face. Accordingly, even if the lamp is arranged to be closely contacted, a uniform radiation distribution will not be obtained. If the irradiation equipment is made to be provided with a window of synthetic quartz, the distance in oxygen environment can be made uniform and uniform radiation distribution will be obtained.

When discharge by non-electrode electric field is used, it is not necessary to make an outer electrode into mesh texture. Glow discharge spreads to the whole electric discharge space only by preparing an outer electrode in a part of lamp external surface. As an outer electrode, an electrode made of an aluminum block which also serves as a light reflector of light is usually used for the lamp back. However, an outside diameter of a lamp is also as large as a lamp used for dielectric barrier discharge, synthetic quartz is needed in order to make it uniform radiation distribution.

The most distinctive feature of a small tube excimer lamp is that its structure is simple. Both ends of a silica tube are closed and a gas for performing excimer luminescence is only enclosed inside of the tube.

An outer diameter of a pipe of a small tube lamp is about 6 nm to 12 nm, and when it is too large, high voltage is needed for starting.

Any one of dielectric barrier discharge and non-electrode electric field discharge can be used for the mode of electric discharge. As for the shape of electrode, although the face which touches a lamp may be a plane, if the shape of electrode is made to be corresponded to the curve of the lamp, it can fix the lamp firmly, and electric discharge is stabilized more by the electrode being closely contacted with the lamp. Moreover, if a curved surface is made into a mirror surface with aluminium, it will also become a light reflector.

Xe excimer lamp emits a ultraviolet ray of a single short wavelength of 172 nm, and it is excellent in luminous efficiency. This light has a large absorption coefficient of oxygen, high concentration of a radical oxygen atom species and ozone can be generated with very a small quantity of oxygen.

Moreover, it is known that the light energy of a short wavelength of 172 nm has a high potential to dissociate a bond in an organic substance.

Property modification of polysilazane film is realizable in a short time with the high energy which is possessed by this active oxygen, ozone, and ultraviolet radiation.

Therefore, compared with a low-pressure mercury lamp emitting a wavelength of 185 nm or 254 nm and plasma washing, it is possible to shorten the process time due to high throughput or decrease of equipment area, and it becomes possible to irradiate to an organic material or to a plastic substrate which is easy to receive the damage with heat.

An excimer lamp has a high generating efficiency of light, as a result, it is possible to make the light switch on by an injection of low electric power. Moreover, it is not emitted a light with a long wavelength leading to a temperature increaser, but since it emits energy of a single wavelength in a ultraviolet light region, it has a distinctive feature of suppressing an increase of a surface temperature of an exposure subject. For this reason, it is suitable for flexible film materials, such as PET which is supposed to be easy to be affected by heat.

(Irradiation intensity of vacuum ultraviolet light)

When the irradiation intensity is high, the probability of collision between a photon and a chemical bond in polysilazane increases, whereby the duration of the conversion reaction can be shortened. Also, since the number of photons which penetrate into inside increases, the thickness of converted layer is increased and /or the improvement of the layer quality (densifying the layer) becomes possible.

However, too long duration of irradiation may cause deterioration of flatness or damage to materials other than the barrier film. Although the advance degree of the reaction is generally evaluated in terms of integral light quantity which is expressed by the product of irradiation intensity and irradiation time, there may be a case in which the absolute value of irradiation intensity is important.

Therefore, in the present invention, it is preferable to conduct a conversion treatment in which the maximum irradiation intensity of 100 $mW/cm^2$ - 200 $mW/cm^2$ at least once in a VUV irradiation process, in view of suppressing the damage of lamp or the member of a lamp unit, and attaining both improvement of conversion efficiency and barrier property.

(Irradiation time of vacuum ultraviolet light (VUV))

The irradiation time in which vacuum ultraviolet light (VUV) is applied may be arbitrarily selected. However, the irradiation time in the irradiation process is preferably 0.1 second - 3 minutes and more preferably 0.5 second - 1 minute, in view of damage to the substrate and occurrence of film defect, and of reducing the fluctuation of gas barrier performance.

(Oxygen concentration at vacuum ultraviolet light (VUV) irradiation)

The oxygen concentration at the time ofvacuum ultraviolet light (VUV) irradiation is preferably 500 ppm - 10000 ppm (1%) and more preferably 1000 ppm - 5000 ppm.

By controlling the oxygen concentration within the above range, degradation of the barrier property can be avoided by preventing formation of an oxygen excess barrier film.

Further, unnecessarily long time to replace with air can be prevented, simultaneously, increase in the amount of air (containing oxygen) caught up into the vacuum ultraviolet light (VUV) irradiation chamber via the web conveyance in a continuous production such as a roll to roll method can be suppressed, and, further, inability of oxygen concentration control can be prevented.

Oxygen source necessary to the modification reaction is enough, because oxygen and very small amount of water are incorporated into the polysilazane-containing layer while coating, and, further, there exists adsorbed oxygen or water on the substrate other than the coated layer.

Also, as described above, the efficiency of the treatment using light tends to be degraded due to the decrease in the amount of light having a wavelength of 172 nm reaches the film surface due to the absorption of the light of 172 nm by oxygen.

When the coated layer is irradiated with vacuum ultraviolet light (VUV), the modification treatment is preferably conducted under a condition in which the oxygen concentration is as low as possible, and the VUV light can effectively reach the coated layer.

This is the point which is largely different between the atom accumulation method such as a CVD method in which a film having a controlled composition ratio in advance, and the method containing formation of precursor film via coating + a modification treatment.

When the coated layer is irradiated with vacuum ultraviolet light (VUV), it is preferable that a dry inert gas is used besides an oxygen gas, and, specifically, it is preferable to use a dry nitrogen gas in view of the cost. The oxygen concentration can be controlled by changing the flow ratios of the oxygen gas and the inert gas introduced into an irradiation chamber.

[Other constituting layers]

(Anchor coat agent layer)

An anchor coat agent layer may be provided on the substrate surface according to the present invention for the purpose of improving adhesiveness with a coated layer.

Examples of an anchor coat agent used for the anchor coat agent layer include a polyester resin, an isocyanate resin, an urethane resin, an acrylic resin, an ethylene vinyl alcohol resin, a modified vinyl resin, an epoxy resin, a modified styrene resin, a modified silicon resin, and alkyltitanate, which may be used alone or in combination of two or more kinds thereof

A conventionally well-known additive agent can also be added to these anchor coat agents. The anchor coating may be conducted by applying an anchor coating agent such as described above on a substrate via a method known in the art, for example, a roll coat method, a gravure coat method, a knife coat method, a dip coat method, and a spray coat, followed by drying to remove such as a solvent or a dilution agent. The applying amount of the anchor coating agent as aforementioned is preferably around 0.1 to 5 g/$m^2$ (under a dried condition).

(Smooth layer)

The gas barrier film of the present invention may have a smooth layer.

The smooth layer of the present invention is provided in order to flatten the crude surface of a transparent resin film substrate having protrusions or to flatten the transparent inorganic layer having asperity or pinholes due to the protrusions existing on the transparent resin film substrate. Such a smooth layer is basically formed by hardening a photosensitive resin.

As a photosensitive resin used for a smooth layer, cited may be, for example, a resin composition containing an acrylate compound having a radically reactive unsaturated compound, a resin composition containing a mercapto compound having an acrylate compound and a thiol group, and a resin composition in which dissolved is a multifunctional acrylate monomer such as an epoxy acrylate, an urethane acrylate, a polyester acrylate, a polyether acrylate, a polyethyleneglycol acrylate, or glycerol methacrylate. Further, it is also possible to use an arbitrary mixture of the above resin composites. The photosensitive resin is not specifically limited as far as it contains a reactive monomer having one or more photopolymerizable unsaturated bond in the molecule.

The method of forming a smooth layer is not specifically limited, however, preferably employed are wet methods, for example, a spin coating method, a spray coating method, a blade coating method, and a dip coating method, and dry coating methods, for example, a vacuum evaporation method.

In the smooth layer forming process, an additive such as an antioxidant, an ultraviolet absorber or a plasticizer may be added in the aforementioned photosensitive resin, if needed. An appropriate resin or an additive may be added in any smooth layer irrespective of the laminate position in order to improve the film forming property or to avoid occurrence of pin holes.

The flatness of a smooth layer is a value expressed by the surface roughness described in JIS B 0601, and the maximum profile peak height Rt (p) is preferably 10 nm or more, but 30 nm or less. When the Rt(p) value is smaller than this range, the coating property may be lost in the step of applying a silicon compound, which will be described later, in the occasion when a coating means becomes in contact with the smooth layer in a coating method such as a wire bar method or a wireless bar method. Or, when the Rt(p) value is larger than this range, it may become difficult to smooth the irregularity after applying a silicon compound.

(Bleedout preventing layer)

A bleedout preventing layer is provided on the surface of a substrate opposite to the surface on which the smooth layer is provided, in order to avoid the contamination of the contact layer due to the migration of such as an unreacted oligomer from the inside of the substrate to the surface, when a film having a smooth layer is heated. As far as the bleedout preventing layer has this function, the bleedout preventing layer may have the same constitution as that of the smooth layer.

As an unsaturated organic compound having a polymerizable unsaturated group, which may be incorporated in a bleedout prevention layer, a polyvalent unsaturated organic compound having two or more polymerizable unsaturated groups in the molecule or a monovalent unsaturated organic compound having one polymerizable unsaturated group in the molecule may be cited.

Here, examples of a multivalent unsaturated organic compound include: ethylene glycol di(meth)acrylate, diethylene glycol di(meth)acrylate, glycerol di(meth)acrylate, glycerol tri(meth)acrylate, 1,4-butanediol di(meth)acrylate, 1,6-hexanediol di(meth)acrylate, neo-pentyl glycol di(meth)acrylate, trimethylolpropane tri(meth)acrylate, dicyclopentanyl di(meth)acrylate, pentaerythritol tri(meth)acrylate, pentaerythritol tetra(meth)acrylate, dipentaerythritol hexa(meth) acrylate, dipentaerythritol monohydroxypenta (meth)acrylate,ditrimethylolpropane tetra(meth)acrylate, diethylene glycol di(meth)acrylate, polyethylene glycol di(meth)acrylate, tripropylene glycol di(meth)acrylate, and polypropylene glycol di (meth)acrylate.

Here, examples of a monovalent unsaturated organic compound include: methyl (meth)acrylate, ethyl (meth) acrylate, propyl (meth)acrylate, butyl (meth)acrylate, 2-ethylhexyl (meth)acrylate, isodecyl (meth)acrylate, lauryl (meth) acrylate, stearyl (meth)acrylate, allyl (meth)acrylate, cyclohexyl (meth)acrylate, methylcyclohexyl (meth)acrylate, isobomyl (meth)acrylate, 2-hydroxyethyl (meth)acrylate, 2-hydroxypropyl (meth)acrylate, glycerol (meth)acrylate, glycidyl (meth)acrylate, benzyl (meth)acrylate, 2-ethoxyethyl (meth)acrylate, 2-(2-ethoxyethoxy)ethyl (meth)acrylate, butoxyethyl (meth)acrylate, 2-methoxyethyl (meth)acrylate, methoxydiethylene glycol (meth)acrylate, methoxytriethylene glycol

(meth)acrylate, methoxypolyethylene glycol (meth)acrylate, 2-methoxypropyl (meth)acrylate, methoxydipropylene glycol (meth)acrylate, methoxytripropylene glycol (meth)acrylate, methoxypolypropylene glycol (meth)acrylate, polyethylene glycol (meth)acrylate, and polypropylene glycol (meth)acrylate.

As other additive agents, a matting agent may be incorporated. As a matting agent, inorganic particles having an average particle diameter of 0.1 μm - 5 μm are preferably used. As such inorganic particles, one kind or two or more kinds in combination of silica, alumina, talc, clay, calcium carbonate, magnesium carbonate, barium sulfate, aluminum hydroxide, titanium dioxide or zirconium dioxide may be used.

The matting agent containing inorganic particles is desirably contained in a ratio of 2 mass parts or more, preferably 4 mass parts or more, and more preferably 6 mass parts or more, but 20 mass parts or less, preferably 18 mass parts or less, and more preferably 16 mass parts or less, in total solid content of 100 mass parts.

The bleedout preventing layer may contains a thermoplastic resin, a thermocurable resin, an ionizing radiation curable resin, and a photopolymerizable resin, beside a hard coat agent and matting agent

The bleedout preventing layer as described above can be prepared as follows. A coating solution is prepared by mixing a hard coat agent, a matting agent, and other components if required, and a diluting solvent used when required. The prepared coating solution is coated on a surface of a substrate film with a conventionally known method. Then it is cured by irradiation with an ionization radiation rays.

As a method of irradiation with an ionization radiation rays, it is irradiated with ultraviolet rays in the range of 100 - 400 nm, or preferably, in the range of 200 - 400 nm emitted from: a super-high-pressure mercury lamp, a high-pressure mercury lamp, a low-pressure mercury lamp, a carbon ark, or a metal halide lamp.

A thickness of the bleedout preventing layer of the present invention is preferably 1 μm - 10 μm, and more preferably, it is 2 μm - 7 μm, in view of improving the heat resistance of the film, easy adjustment the balance of optical properties of the film, and preventing the curl when a bleedout preventing layer is provided on only one side of the gas barrier film.

<<Organic photoelectric conversion element>>

[Sealing material]

A gas barrier film of the present invention can be used as various sealing materials or sealing films. Of these, it is a character that a gas barrier film of the present invention is used as a sealing film for an organic photoelectric conversion element.

Since the barrier film of the present invention is transparent, when it is used for an organic photoelectric conversion element, this barrier film can be used as a substrate and the element can be constructed so that sun light is introduced from this side. Namely, a transparent conductive layer such as an ITO layer can be provided as a transparent electrode to construct a resin substrate for an organic photoelectric conversion element. An organic photoelectric conversion element can be sealed off by: forming a porous semiconductor layer on an ITO transparent conductive layer use as an anode provided on a substrate; providing a cathode constituted of a metal layer to form an organic photoelectric conversion element; and laminating another sealing material (which may be the same as the above barrier film), followed by adhering the aforementioned barrier film substrate and the peripheral to seal off the element, whereby an adverse affect of the outside moisture or oxygen gas to the element can be prevented.

The resin substrate for an organic photoelectric conversion element is obtained by forming a transparent conductive film on the gas barrier layer of thus obtained barrier film.

Formation of a transparent conductive film can be conducted by using, for example, a vacuum evaporation method or a sputtering method. It can also be formed via a coating method, for example, by employing a sol-gel method using, for example, alkoxides of indium and tin. The (average) thickness of a transparent conductive film is preferably 0.1 nm -1,000 nm.

Subsequently, an organic photoelectric conversion element using the barrier film of the present invention will be explained.

[Sealing film and production method thereof]

In the present invention, it is characterized that the gas barrier film of the present invention is used as a substrate in the sealing film according to the present invention.

By using a barrier film of the present invention, a transparent conductive layer is formed on a gas barrier layer, and by using this as an anode, a layer constructing an organic photoelectric conversion element is formed on the anode, a layer to be used as a cathode is further laminated, and another barrier film is laminated thereon as a sealing film, followed by adhering to seal.

Specifically, a metal foil on which resin laminate (a polymer film) is formed is preferably used as a sealing film

for a purpose in which ejection of light is not expected (transparency is not required) because of low cost and, further, a low permeability, although it cannot be used as a barrier film on the light ejecting side.

In the present invention, a metal foil means a foil or a film of a metal produced, for example, by rolling, and it is distinguished from a thin film of a metal formed via sputtering or vacuum evaporation, or from an electrically conductive film formed from a fluid electrode material such as an electrically conductive paste.

The metal element of a metal foil is not specifically limited, and cited may be a copper (Cu) foil, an aluminum (Al) foil, a gold (Au) foil, a brass foil, a nickel (Ni) foil, a titanium (Ti) foil, a copper alloy foil, a stainless steel foil, a tin (Sn) foil and a high nickel-content-alloy foil. Among these various metal foils, an aluminum foil may be cited as a specifically preferable metal foil.

The thickness of a metal foil is preferably 6 - 50 μm. When the thickness is less than 6 μm, pin holes may occur in the metal foil depending on the used material, whereby necessary barrier property (for example, a moisture permeability or an oxygen permeability) may not be obtained. When the thickness exceeds 50 μm, a problem of a higher cost may occur, or the merit of using a film may be lost since the thickness of the organic photoelectric conversion element becomes large.

In a metal foil having a resin film (a polymer film) laminated thereon, the various materials described in "KINOUSEI HOUSOUZAIRYO NO SHINTENKAI (New development of functional wrapping materials)"(published by Toray Research Center, Inc.) may be used for the resin film, examples of which include: a polyethylene resin, a polypropylene resin, a polyethylene terephthalate resin, a polyamide resin, an ethylene-vinyl alcohol copolymer resin, an ethylene-vinyl acetate copolymer resin, an acrylonitrile-butadiene copolymer resin, a cellophane resin, a vinylon resin and a vinylidene chloride resin. Resins such as a polypropylene resin and a nylon resin may be stretched, or, further, may be coated with a vinylidene chloride resin. With respect to a polyethylene resin, a low density resin or a high density resin can be used.

Although will be mentioned later, as a method to seal two films, for example, a resin layer which can be thermally fused using a commonly used impulse sealer is laminated, and sealed using an impulse sealer by fusing. In this case, the (average) thickness of a barrier film is preferably 300 μm or less since, when it is more than 300 μm, the handling property of the films and the thermal fusing property, for example, using an impulse sealer becomes more difficult in a sealing process of barrier films.

[Sealing of organic photoelectric conversion element]

In the present invention, an organic photoelectric conversion element can be sealed by: forming a transparent conductive layer on a resin film having thereon a gas barrier layer of the present invention (a gas barrier film), forming each layer of an organic photoelectric conversion element on the obtained resin substrate for an organic photoelectric conversion element; and covering the cathode surface with the aforementioned sealing film under a purged circumstance with an inert gas.

As an inert gas, a rare gas such as He or Ar is preferably used besides $N_2$. A rare gas obtained by mixing He and Ar is also preferably used. The ratio of a rare gas in the gas phase is preferably from 90 to 999 volume%. The storage stability of the organic photoelectric conversion element is improved by sealing under a purged circumstance with an inert gas.

When an organic photoelectric conversion element is sealed using the aforementioned metal foil laminated with a resin film (a polymer layer), it is preferable that a layer containing a ceramic layer is formed on a metal foil, and the surface of the layer containing the ceramic layer is adhered onto the cathode of the organic photoelectric conversion element, but not the surface of the resin film laminated on the metal foil. When the polymer layer side is adhered onto the cathode, it may occasionally happen that electrical conduction partially occurs.

As the method to adhere a sealing film onto the cathode of an organic photoelectric conversion element, cited may be a method to laminate a film which is commonly used and can be thermally fused using an impulse sealer, for example, an ethylene-vinyl acetate copolymer (EVA) film, a polypropylene (PP) film or a polyethylene (PE) film, followed by sealing using an impulse sealer by fusing.

As an adhesion method, a dry lamination method is excellent in view of workability. In this method, a curable adhesives layer of about 1.0 to 2.5 μm thick is generally used. However, since the adhesive may tunnel, bleed out or cause wrinkles by shrinking when the applied amount of the adhesive is too much, the applied amount of the adhesive is preferably adjusted within 3 to 5 μm as a dried film.

A hot melt lamination method is a method to melt a hot melt adhesive agent and apply onto a substrate to form an adhesive layer. In this method, the thickness of the adhesive layer can be selected in a wide range of 1 to 50 μm. As a base resin of a generally used hot melt adhesive agent, for example, EVA, an ethylene-ethylacrylate copolymer resin (EEA), polyethylene, and butyl rubber are usable. Also, for example, rosin, a xylene resin, a terpene resin or a styrene resin is used as an adhesiveness providing agent, and, for example, a wax is used as a plasticizer.

The extrusion lamination method represents a method to apply a resin melted at a high temperature onto a substrate using a die. In this method, it is possible to select the thickness of the resin layer within a wide range of 10 to

50 μm.

As a resin used for the extrusion lamination method, for example, a low density polyethylene (LDPE), EVA and PP are generally usable.

[Ceramic layer]

In the gas barrier film of the present invention, when sealing an organic photoelectric conversion element, it can be additionally provided on the gas barrier film with a ceramic layer made of the compounds such as inorganic oxide, nitride, and carbide from the viewpoint of increasing a gas barrier property more.

Specific ceramic films are formed, for example, by: $SiO_x$, $Al_2O_3$, $In_2O_3$, $TiO_x$, ITO(Indium tin oxide), AlN, $Si_3N_4$, $SiO_xN$, $TiO_xN$, and SiC.

The ceramic layer may be laminated by well-known techniques, such as sol-gel process, vapor-depositing method, CVD, PVD, and sputtering method. For example, it can also be formed by the same way as formation of the polysilazane coated layer using polysilazane. In this case, after applying the composion containing polysilazane and forming a coated layer of polysilazane, it can be formed by converting it into a ceramic.

Moreover, the ceramic layer concerning the present invention can be selectively formed by choosing conditions of ingredients (it is also called as raw materials.), such as an organometallic compound, decomposition gas, decomposition temperature, and injection electric power, in an atmospheric pressure plasma method. It can be selectively formed by choosing a metallic oxide mainly composed of silicon oxide, and a mixture of metallic carbide, metallic sulfide, and metallic halide (such as metallic oxynitride and metallic oxihalide).

For example, if a silicon compound is used as a raw material compound and oxygen is used for decomposition gas, a silicon oxide will be generated. Moreover, if silazane is used as a raw material compound, silicon oxynitride will be generated. The reason of this is as follows. In a plasma space, there exist very active charged particles and active radicals in a high density, as a result, a chemical reaction of multi-steps will be extremely accelerated in a plasma space to result in being changed into a thermodynamically stable compound in an extremely short time.

As a raw material for forming this ceramic layer, as long as it is a silicon compound, any states of a gas, a liquid, and a solid under normal temperature and ordinary pressure may be used. When it is a gas, it can be introduced as it is in an electric discharge space, but when it is a liquid or a solid, it is used, making it evaporate by heating, babbling, a reduced pressure, ultrasonic irradiation, or other means. Moreover, it may be used by diluting with a solvent, and organic solvents such as methanol, ethanol, and n-hexane, and a mixed solvent thereof can be used as a solvent. In addition, since these diluting solvents are decomposed into a state of a molecule or an atom during a plasma electric discharge process, their influences can be almost ignored.

Examples of such silicon compound include:

silane, tetramethoxysilane, tetraethoxysilane, tetra-n-propoxysilane, tetra-iso-propoxysilane, tetra-n-butoxysilane, tetra-t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl) trimethoxysilane, hexamethyldisiloxane, bis(dimethylamino)dimethylsilane, bis(dimethylamino)methyl vinyl silane, bis(ethylamino) dimethylsilane, N,O-bis(trimethylsilyl)acetamide, bis (trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakis dimethylaminosilane, tetra-isocyanate silane, tetramethyldisilazane, tris(dimethylamino)silane, methoxyfluorosilane, allyldimethylsilane, allyltrimethylsilane, benzyltrimethylsilane, bis(trimethylsilyl)acetylene, 1,4-bistrimethylsilyl-1,3-butadiine, di-t-butylsilane, 1,3-disilabutane, bis(trimethylsilyl)methane, cyclopentadienyltrimethyl silane, phenyldimetylsilane, phenyltrimethylsilane, propargyltrimethylsilane, tetramethylsilane, trimethylsilyl acetylene,1-(trimethylslyl)-1-propyne, tris(trimethylsilyl) methane, tris(trimethylsilyl)silane, vinyl trimethylsilane, hexamethyldisilane, octamethylcyclo-tetra-siloxane, tetramethylcyclo-tetra-siloxane, hexamethylcyclo-tetra-siloxane, and M silicate 51 (produced by TAMA KAGAKU Co., Ltd.)

Examples of a decomposing gas to produce a ceramic layer by decomposing a raw material gas containing silicon include: a hydrogen gas, a methane gas, an acetylene gas, a carbon oxide gas, a carbon dioxide gas, a nitrogen gas, an ammonia gas, a nitrous oxide gas, a nitrogen oxide gas, a nitrogen dioxide gas, an oxygen gas, water vapor, a fluorine gas, hydrogen fluoride, trifluoroalcohol trifluorotoluene, hydrogen sulfide, sulfur dioxide, carbon disulfide, and a chlorine gas.

By suitably selecting: a raw material gas containing silicon; and a decomposing gas, it can be produced a ceramic layer containing silicon oxide, nitride or carbide.

In an atmospheric pressure plasma method, a discharge gas which easily becomes in a plasma state is mixed to these reactive gases, and the mixed gas is supplied in a plasma discharge generating apparatus. Examples of such discharge gas include: a nitrogen gas and/or an element of Group 18 of the periodic table. Specific gases used are:

helium, neon, argon, krypton, xenon, and radon. Of these, nitrogen, helium and argon are specifically preferably used.

The above-described discharge gas is mixed with a reactive gas to form a thin film forming (mixture) gas. This gas is supplied in a plasma discharge generating apparatus (plasma generating apparatus) to form a thin film. Although a ratio of a discharge gas to a reactive gas depends on the property of the film to be obtained, the reactive gas is provided with setting a ratio of the discharge gas to be 50% or more with respect to the mixture gas.

In the laminated ceramic layer constituting the gas barrier resin substrate relating to the present invention, it can be obtained a ceramic layer mainly composed of silicon oxide of the present invention containing a silicon atom and at least one of O atom and N atom, by combining a predetermined ratio of oxygen gas or nitrogen gas with the above-described organic silicon compound

As a thickness of the ceramic layer of the present invention, it is preferable in the range of 10 to 2,000 nm by considering a gas barrier property and transparency. Further, by considering also flexibility, and in order to achieve suitably balanced total properties, it is preferable to be 10 to 200 nm.

Subsequently, each layer of organic photoelectric conversion element materials (a constitution layer) constituting an organic photoelectric conversion element will be explained.

(Constitution of organic photoelectric conversion element)

Preferable embodiments of an organic photoelectric conversion element relating the present invention will be explained, however, the present invention is not limited thereto. The organic photoelectric conversion element is not specifically limited as far as it contains an anode, a cathode and at least one electric power generation layer (a mixed layer of a p-type semiconductor and an n-type semiconductor, also referred to as a bulk heterojunction layer or an i layer), and is an element which generates electricity when irradiated with light.

Preferable examples of the layer constitution of an organic photoelectric conversion element will be shown below.

(1) Anode / power generation layer / cathode
(2) Anode / hole transport layer / power generation layer / cathode
(3) Anode / hole transport layer / power generation layer / electron transport layer / cathode
(4) Anode / hole transport layer / p-type semiconductor layer / power generation layer / n-type semiconductor layer / electron transport layer / cathode
(5) Anode / hole transport layer / 1st luminescence layer / electron transport layer / intermediate electrode / hole transport layer / 2nd luminescence layer / electron transport layer / cathode

The power generation layer needs to contain a p-type semiconductor material which can convey an electron hole, and an n-type semiconductor material which can convey an electron. These materials may form a heterojunction with substantially two layers or may form a bulk heterojunction with one layer inside of which is of a mixed state, while the bulk heterojunction is preferred in view of a higher photoelectric conversion efficiency. The p-type semiconductor material and the n- type semiconductor material will be described later.

As the same as the case of an organic EL element, the efficiency of taking out holes and electrons to the anode and the cathode, respectively, can be improved by sandwiching the power generation layer with a hole transport layer and an electron transport layer. Accordingly, the constitutions having those (namely, (2) and (3)) are more preferable. The power generation layer itself may also be of a constitution in which the power generation layer is sandwiched between a layer containing a p-type semiconductor material and a layer containing an n-type semiconductor material as shown in (4) (also referred to as p-i-n constitution) in order to improve the rectification property of holes and electrons (namely, selectivity of carriers taken out). Further, in order to improve the utilization efficiency of the sunlight, it may be of a tandem constitution (layer constitution (5)) in which sun light of different wavelength can be absorbed by respective power generation layers.

For the purpose of improvement in a natural sunlight utilization factor (photoelectric conversion efficiency), it is possible to make an organic photoelectric conversion element having a composition of a back contact type in place of the sandwich structure in the organic photoelectric conversion element 10 shown in FIG. 3, the back contact type having a composition of forming a hole transport layer 14 and an electron transport layer 16 on a pair of comb dentate electrodes, and a photoelectric conversion section is arranged thereon.

A preferable embodiment of an organic photoelectric conversion element relating to the present invention will be described in the following.

FIG. 2 is a cross-sectional view showing an example of a solar cell having an organic photoelectric conversion element of a bulk heterojunction type. In FIG. 2, an organic photoelectric conversion element 10 of a bulk heterojunction type has a successively laminated structure on one surface of a substrate 11: a anode 12, a hole transport layer 17, a photoelectric conversion layer 14 of a bulk heterojunction type, an electron transport layer 18 and a cathode 13.

The substrate 11 is a member holding successively laminated members of: the anode 12, the photoelectric

conversion layer 14 and the cathode 13. In this embodiment, since the incident light by which photoelectric conversion is carried out enters from the substrate 11 side, the substrate 11 is a member which enables to pass through this light by which photoelectric conversion is carried out, i.e., it is a transparent member to the wave length of this light that should be carried out photoelectric conversion. As for the substrate 11, a glass substrate and a resin substrate are used, for example. This substrate 11 is not indispensable. For example, the organic photoelectric conversion element 10 of a bulk heterojunction type may be formed by forming the anode 12 and the cathode 13 on both surfaces of the photoelectric conversion layer 14.

The photoelectric conversion layer 14 is a layer which converts light energy into electric energy, and it is composed ofabulk heterojunction layer uniformly mixed with a p-type semiconductor material and an n-type semiconductor material. A p-type semiconductor material functions relatively as an electron donor (donor), and an n-type semiconductor material functions relatively as an electron acceptor (acceptor).

In FIG. 2, the incident light entering to the anode 12 through the substrate 11 is absorbed by an electron donor or an electron acceptor in the bulk heterojunction layer of the photoelectric conversion layer 14. An electron is transferred from the electron donor to the electron acceptor to form a pair of electron and hole (charge separation state). The generated electric charge is transported by an internal electric field, for example, the electric potential difference of the anode 12 and the cathode 13 when the work function of the anode 12 and the cathode 13 are different An electron passes through electron acceptors, while a hole passes through electron donors, and the electron and the hole each are respectively transported to a different electrode, and a photocurrent is detected. For example, when the work function of the anode 12 is larger than the work function of the cathode 13, the electron is transported to the anode 12 and the hole is transported to the cathode 13. In addition, if the size of a work function is reversed, the electron and the hole will be transported to the reverse direction to that described above. Moreover, the transportation direction of an electron and a hole is also controllable by applying a potential between the anode 12 and the cathode 13.

In addition, although not described in FIG. 2, it may possible to have other layers, such as a hole blocking layer, an electron blocking layer, an electron injection layer, a hole injection layer, or a smoothing layer.

More preferable structure is a structure in which the above-mentioned photoelectric conversion layer 14 shown in FIG. 3 is composed of three layered structure of so-called p-i-n structure. The usual bulk heterojunction layer is a single layer 14i containing a p-type semiconductor material and an n-type semiconductor material mixed with each other. By sandwiching the 14i layer with a 14p layer composed of a p-type semiconductor material single substance and a 14n layer composed of an n-type semiconductor material single substance, the rectifying property of a hole and an electron becomes higher, the loss caused by the recombination of a hole and an electron which carried out charge separation is reduced, and still higher photoelectric conversion efficiency can be acquired by this structure.

Furthermore, it is also possible to make a tandem type structure produced by laminating a plurality of the aforesaid photoelectric conversion elements for the purpose of improving a sunlight utilization factor (photoelectric conversion efficiency).

FIG. 4 is a cross-sectional view showing a solar cell having an organic photoelectric conversion element containing bulk heterojunction layers of a tandem type. A tandem type structure can be made as follows. After laminating the anode 12 and the first photoelectric conversion layer 14' successively on the substrate 11, a charge recombination layer 15 is laminated. Then, a second photoelectric conversion layer 16 and the cathode 13 are laminated to achieve a tandem type structure. The second photoelectric conversion layer 16 may be a layer which absorbs the same spectrum as an absorption spectrum of the first photoelectric conversion layer 14', or it may be a layer which absorbs a different spectrum. Preferably, the second photoelectric conversion layer 16 absorbs a different spectrum from that of the first photoelectric conversion layer 14'. Moreover, both the first photoelectric conversion layer 14' and the second photoelectric conversion layer 16 may be three layered lamination structure of p-i-n as mentioned above.

Hereafter, composing materials of these layers will be described.

[Materials for organic photoelectric conversion element]

(p-type semiconductor material)

In the present invention, as a p-type semiconductor material used for the photoelectron conversion layer (bulk heterojunction layer), various types of condensed polycyclic aromatic compounds and conjugated polymers and oligomers are cited.

Examples of a condensed polycyclic aromatic low molecular weight compound include: anthracene, tetracene, pentacene, hexacene, heptacene, chrysene, picene, fulminene, pyrene, peropyrene, perylene, terylene, quoterylene, coronene, ovalene, circumanthracene, bisanthene, zethrene, heptazethrene, pyanthrene, violanthene, isoviolanthene, circobiphenyl, anthradithiophene; porphyrin, copper phthalocyanine; tetrathiafulvalene (TTF) - tetracyanoquinodimethane (TCNQ) complex, bis (ethylenedithio) tetrathiafulvalene (BEDT - TTF) - perchloric acid complex; and a derivative or a precursor thereof

As examples of a derivative containing a condensed polycyclic compound include: pentacene compounds having a substituent disclosed in WO 03/16599, WO 03/28125, US 6,690,029, and JP-A No. 2004-107216; pentacene precursors disclosed in US 2003/136964; a trialkylsilylethynyl group substituted acenes and their derivatives disclosed in J. Amer. Chem. Soc., voL 127, No. 14, p. 4986, J. Amer. Chem. Soc., vol. 123, p. 9482, and J. Amer. Chem. Soc., vol. 130 (2008), No. 9, p. 2706.

Examples of a conjugated polymer include: polythiophene such as 3-hexylthiohene (P3HT) and its oligomer, polythiophene having a polymerizable group disclosed in Technical Digest of the International PVSEC-17, Fukuoka, Japan, 2007, P.1225, polythiophene-thienothiophene copolymer disclosed in Nature Material, (2006) Vol. 5, p. 328, polythiophene-diketopyrrolopyrrole copolymer disclosed in WO 2008/000664, polythiophene-thiazolothiazole copolymer disclosed in Adv. Mat., p. 4160 (2007), polythiophene copolymer disclosed in Nature Material, Vol. 6, p. 497 (2007), polypyrrole and its oligomer, poly aniline, polyphenylene and its oligomer, polyphenylene vinylene and its oligomer, poly thienylene vinylene and its oligomer, polyacethylene, polydiacetylene, $\sigma$ conjugated polymers such as polysilane and polygerman.

Suitably usable oligomers rather than polymers are: thiophene hexamers such as: $\alpha$-sexithionene $\alpha,\omega$-dihexyl-$\alpha$-sexithionene, $\alpha,\omega$-dihexyl-$\alpha$-quinquethionene, and $\alpha,\omega$-bis(3-butoxypropyl)-$\alpha$-sexithionene.

Among these, referred are compounds which has a sufficient high solubility to an organic solvent to be able to carry out a solution process, and which forms a crystalline thin film and can realize a high mobility after dying

When an electron transporting layer is fomned on a photoelectric conversion layer with a coating method, since there may occur the problem that the solution for the electron transporting layer may dissolve the photoelectric conversion layer, it can be used a material which will become insoluble after forming a layer with a solution process.

Examples of such materials include: a polythiophene compound having a polymerizable group which becomes insoluble through cross-linked polymerization after being coated as described in Technical Digest of the International PVSEC-17, Fukuoka, Japan, 2007, p. 1225; a compound having a solubilizing group which becomes insoluble (becomes to a pigment) by addition of thermal energy as described in US 2003/136964 and JP-A No. 2008-16834.

(n-type semiconductor material)

In the present invention, there is no limitation in particular to an n-type semiconductor material used in the bulk heterojunction layer. Examples of such n-type semiconductor material include: fullerene, octaazaporphyrin, a perfluoro compound of a p-type semiconductor (perfluoropentacene and perfluorophthalocyanine), a polymer compound which contains an aromatic carboxylic acid anhydride and its imide in the structure, such as naphthalenetetracarboxylic anhydride, naphthalenetetracarboxylic diimide, perylenetetracarboxylic anhydride, and perylenetehecarboxylic diimide.

Among them, a fullerene derivative is most preferably used since it ca be expected high charge separation ability (high-speed electron injection at a speed of 50 fs) with an interaction with a p-type semiconductor material. Examples of a fullerene derivative include: fullerene $C_{60}$, fullerene $C_{70}$, fullerene $C_{76}$, fullerene $C_{78}$, fullerene $C_{84}$, fullerene $C_{240}$, fullerene $C_{540}$, mixed fullerene, fullerene nano-tube, multi layer nano-tube, mono layer nano-tube, and nano-hom (cone type) and a fullerene derivative a part of which is substituted with a hydrogen atom, a halogen atom, a substituted or unsubstituted alkyl group, an alkenyl group, an alkynyl group, an aryl group, a heteroaryl group, a cycloalkyl group, a silyl group, an ether group, a thioether group, an amino group or a silyl group.

Among these, it is preferable to use a fullerene derivative which has an improved solubility by introduction of a substituent. Examples thereof are: [6,6]-phenyl C61-butyric acid methyl ester (abbreviated name PCBM), [6,6]-phenyl C61-butyric acid n-butyl ester (PCBnB), [6,6]-phenyl C61-butyric acid isobutyl ester (PCBiB), [6,6]-phenyl C61-butyric acid n-hexyl ester (PCBH), bis-PCBM described in Adv. Mater., Vol. 20 (2008), p. 2116, amino fullerene described in JP-A No. 2006-199674, metallocene fullerene described in JP-A No. 2008-130889, and fullerene containing a cyclic ether group described in US 7,329,709.

(Hole transport layer · Electron blocking layer)

An organic photoelectric conversion element 10 of the present invention preferably has a hole transport layer 17 between a bulk heterojunction layer and an anode, since the hole transport layer 17 enables to take out effectively the charge generated in the bulk heterojunction layer.

As materials which constitutes the hole transport layer 17, examples are: PEDOT (Baytron™ P, made by Starck-V Tech Co., Ltd.), polyaniline and their dope materials, and cyan compounds described in WO 2006/019270. In addition in a hole transport layer having a shallower LUMO level than the LUMO level ofn-type semiconductor material used for a bulk heterojunction layer, an electron block function is given which has an electron rectifying effect enabling of preventing the generated electrons in the bulk heterojunction layer from flowing to an anode side. This kind of electron transport layer is called as an electron blocking layer. It is preferable to use the electron transport layer having this function. Examples of these materials are: a triarylamine disclosed in JP-A No. 5-271166, metal oxides such as molybdenum

oxide, nickel oxide and tungsten oxide. Moreover, the layer which is made of a single p-type semiconductor material and used for a bulk heterojunction layer can also be used. As a method to form these layers, although it may be used a vacuum deposition method and a solution coating method, it is preferable to use a solution applying method. Before forming a bulk heterojunction layer, it is preferable to form a coated film as an underlaying layer in order to obtain the effect of leveling so that to decrease the leak.

(Electron transport layer · Hole blocking layer)

An organic photoelectric conversion element 10 of the present invention preferably has an electron transport layer 18 between a bulk heterojunction layer and a cathode, since the electron transport layer 18 enables to take out effectively the charge generated in the bulk heterojunction layer.

As an electron transport layer 18, it can be used octaaza porphyrin, and a perfluoro compound of a p-type semiconductor (perfluoropentacene and perfluorophthalocyanine). Similarly, in an electron transport layer which has a deeper HOMO level than the HOMO level of a p-type semiconductor material used in a bulk heterojunction layer, it is provided with a hole blocking function having a rectification effect of preventing a hole generated in the bulk heterojunction layer from flowing to the cathode side. This kind of electron transport layer is also called as a hole blocking layer, and it is preferable to use an electron transport layer having this function. Examples of these materials are: n-type semiconductors of a phenanthrene compound such as bathocuproine, naphthalene tetracarboxylic acid anhydride, naphthalene tetracarboxylic acid diimide, perylene tetracarboxylic acid anhydride, and perylene tetracarboxylic acid diimide; n-type inorganic oxide of titanium oxide, zinc oxide, and gallium oxide; and alkali metal compounds of sodium fluoride, and cesium fluoride. Further, it can also be used a layer made of a single n-type semiconductor used in the bulk heterojunction layer. As a method for forming these layers, although any method of a vacuum deposition method and a solution coating method can be used, a preferably used method is a solution coating method.

(Other layers)

An organic photoelectric conversion element of the present invention may have a composition containing various kinds of inter layers in the element for the purpose of improving energy conversion efficiency or increase of lifetime of an element. Examples of the inter layer include: a hole blocking layer, an electron blocking layer, a hole injection layer, an electron injection layer, an exciton blocking layer, a UV absorbing layer, a light reflective layer, and a wavelength changing layer.

(Transparent electrode (First electrode))

The transparent electrode may be any one of cathode and anode. It may be selected according to the constitution of the photoelectric conversion element. Preferably, a transparent electrode is used for a cathode. For example, when it is used for a cathode, preferable it is an electrode transmitting a light of 380 - 800 nm. Examples of a material which can be used include: transparent metal oxides of indium tin oxide (ITO), $SnO_2$, and ZnO; metal thin film of gold, silver, and platinum; a metal nanowire; and a carbon nanotubes.

Further, it can be used a conductive polymer selected from the group consisting of derivatives of: polypyrrole, polyaniline, polythiophene, polythienylene vinylene, polyazulene, polyisothianaphthene, polycarbazole, polyacethylene, polyphenylene, polyphenylene vinylene, polyacene, polyphenylacetylene, polydiacetylene, and polynaphthalene.

(Counter electrode (Second electrode))

The counter electrode may be an independent layer made of a conductive material. In addition to the material which has conductivity, it may be uses a resin which holds such material together. As a conducting material used for a counter electrode, it can be used: a metal, an alloy, an electric conductive compound, and a mixture thereof which has a small work function (less than 4 eV). Specific examples of such electrode material include: sodium, a sodium potassium alloy, magnesium, lithium, a magnesium / copper mixture, a magnesium / silver mixture, a magnesium / aluminum mixture, a magnesium / indium mixture, an aluminum / aluminium oxide ($Al_2O_3$) mixture, indium, a lithium / aluminium mixture and a rare earth metal. Among these, from the viewpoint of an electron taking out property and resistivity to oxidation, a mixture of these metals and the second metal having a larger work function than these metals is suitable. Examples of these are: a magnesium / silver mixture, a magnesium / aluminum mixture, a magnesium / indium mixture, an aluminum / aluminium oxide ($Al_2O_3$) mixture, a lithium / aluminum mixture and aluminium. A counter electrode can be produced by using these electrode materials with a method such as a vacuum evaporation method or a sputtering method. Moreover, the coating thickness is usually chosen from the range of 10 nm to 5 $\mu$m, and preferably it is chosen from the range of 50 to 200 nm.

When a metallic material is used as a conducting material of a counter electrode, the light arriving at the counter electrode will be reflected and will be also reflected by the first electrode side, and this light can be reused. As a result, the light is again absorbed by the photoelectric conversion layer to result in improvement of photoelectric conversion efficiency. This is desirable.

Moreover, a counter electrode 13 may be a metal (for example, gold, silver, copper, platinum, rhodium, ruthenium, aluminium, magnesium and indium), and nanoparticles, nanowires, or a nanostructure material which is made of carbon. When it is a dispersion of nanowires, a transparent and high conductive counter electrode can be formed by a coating method, and it is desirable.

When the counter electrode side is made to be light transparent, it can be achieved as follows. After producing thin film of a conductive material suitable for counter electrodes, such as an aluminium, an aluminum alloy, silver or a silver compound to have a coating thickness of about 1 to 20 nm (in average), a light transmitting counter electrode can be prepared by providing on the thin film with the membrane of a conductive light transparent material cited in the description of the above-mentioned transparent electrode.

(Intermediate electrode)

As a material required for an intermediate electrode for a tandem structure as described in (5) or in FIG. 4, it is preferable to use a layer having both transparency and conductivity, and it can be used the materials used for the aforesaid transparent electrode (a transparent metal oxide such as ITO, AZO, FTO, and titanium oxide; very thin film of Ag, Al, and Au, for example; a layer containing nanoparticles or nanowires; a conductive polymer such as PEDOT:PSS and polyaniline.

Among the aforesaid hole transport layer and the electron transport layer, there is a combination which acts as an intennediate electrode (a charge recombination layer) when suitably combined and laminated. By making this structure, it can reduce a step to form one layer and this is preferable.

(Metal nanowires)

Examples of a conductive fiber usable in the present invention include: an organic or inorganic fiber which is coated with a metal, a conductive metal oxide fiber, a metal nanowire, a carbon fiber and a carbon nanotube. Among them, a metal nanowire is preferably used.

Generally, metal nanowires indicate a linear structure composed of a metallic element as a main structural element. In particular, the metal nanowires in the present invention indicate a linear structure having a diameter of a nanometer (nm) size.

In order to form a long conductive path by one metal nanowire, and to obtain a suitable light scattering property, a metal nanowire according to the present invention is preferably have an average length of 3 μm or more, more preferably it is 3 to 500 μm, and still more it is 3 to 300 μm. In addition, the relative standard deviation of the length of the conductive fibers is preferably 40% or less. Moreover, from a viewpoint of transparency, a smaller average diameter is preferable, on the other hand, a larger average diameter is preferable from a conductive viewpoint. In the present invention, 10 to 300 nm is preferable as an average diameter of metal nanowires, and it is more preferable to be 30 to 200 nm. Further, the relative standard deviation of the diameter is preferably to be 20% or less.

There is no restriction in particular to the metal composition of the metal nanowire of the present invention, and it can be composed of one sort or two or more metals of noble metal elements or base metal elements. It is preferable that it contains at least one sort of metal selected from the group consisting of noble metals (for example, gold, platinum, silver, palladium, rhodium, iridium, ruthenium and osmium), iron, cobalt, copper and tin. It is more preferable that silver is included in it at least from a conductive viewpoint Moreover, for the purpose of achieving compatibility of conductivity and stability (sulfidation resistance and oxidation resistance of metal nanowire and migration resistance of metal nanowire), it is also preferable that it contains silver and at least one sort of metal belonging to the noble metal except silver. When the metal nanowire of the present invention contains two or more kinds of metallic elements, metal composition may be different between the surface and the inside of metal nanowire, and the whole metal nanowire may have the same metal composition.

In the present invention, there is no restriction in particular to the production means of metal nanowires. It is possible to prepare metal nanowires via various methods such as a liquid phase method or a gas phase method. For example, the manufacturing method of Ag nanowires may be referred to Adv. Mater. 2002, 14, 833 - 837 and Chem. Mater., 2002, 14, 4736 - 4745; a manufacturing method of Au nanowires may be referred to JP-A No. 2006-233252; the manufacturing method of Cu nanowires may be referred to JP-A No. 2002-266007; while the manufacturing method of Co nanowires may be referred to JP-A No. 2004-149871. Specifically, the manufacturing methods of Ag nanowires, described in Adv. Mater., 2002, 14, 833 - 837 and Chem. Mater., 2002, 14, 4736 - 4745, may be preferably employed as a manufacturing method of the metal nanowires according to the present invention, since via those methods, it is

possible to simply prepare a large amount of Ag nanowires in an aqueous system and the electrical conductivity of silver is highest of all metals.

In the present invention, a three-dimensional conductive network is formed by mutual contact of nanowires and high conductivity is achieved. By this, a light can penetrate the window part of the conductive network where metal nanowires do not exist, and further, it becomes possible to perform efficiently the generation of electricity by the scattering effect of the metal nanowires in the organic photoelectric conversion layer portion. When the metal nanowires are arranged in the near place of the organic electric generating section in the first electrode, this light scattering effect can be effectively utilized and it is a preferable embodiment

(Optical function layer)

The organic photoelectric conversion element of the present invention may be provided with a various types of optical function layers for the purpose of efficient light receiving of sunlight. As an optical function layer, there may be provided with an anti-reflection layer, a light condensing layer such as a microlens array, a light diffusion layer which can scatter the light reflected by the cathode and can make the light enter again in a photoelectric conversion layer.

As an anti-reflection layer, well-known anti-reflection layer can be prepared. For example, when a transparent resin film is a biaxial stretching polyethylene terephthalate film, it is preferable to set the refractive index of the adhesion assisting layer, which is adjacent to the film, to be 1.57 to 1.63. This will improve transmittance with decreasing the interface reflection between the film substrate and the adhesion assisting layer. As a way of adjusting a refractive index, it can be carried out by adjusting suitably the ratio of a binder resin to oxide sol having a comparatively high refractive index such as a tin oxide sol and a cerium oxide sol and by coating it Although a single layer of adhesion assisting layer may be sufficient in order to raise adhesion property, a composition of two or more adhesion assisting layers may be used.

As a light collection layer, it can be provides as follows: for example, to arrange a structure of a micro-lens array shape on the sun-light receiving side of the substrate or to make a combination with a so-called light collection sheet to result in increasing an amount of light from the specific direction, or to result in decreasing an incident angle dependency of a sunlight.

In an example of the micro-lens array, square pyramids to realize a side length of 30 $\mu$m and an apex angle of 90 degrees are two-dimensionally arranged on the light extraction side of the substrate. The side length is preferably 10 to 100 $\mu$m. When it is less than the lower limit, coloration occurs due to generation of diffraction effects, while when it exceeds the upper limit, the thickness increases undesirably.

Moreover, as a light scattering layer, a various types of anti-glare layers and a layer in which are distributed nanoparticles or nanowire made of metal or various inorganic oxides in a colorless transparent polymer can be cited.

(Film production method and surface treatment method)

<Formation method of each layer>

As a formation method of a bulk heterojunction layer mixed with an electron acceptor and an electron donor, a transport layer and an electrode, a vacuum deposition method and a coating method (including a cast method and a spin coat method) can be cited. Among these, as a formation method of a bulk heterojunction layer, a vacuum deposition method and a coating method (including a cast method and a spin coat method) can be cited. Among these, a coating method is preferable in order to increase the area of the interface which carries out charge separation of the above-mentioned hole and electron and to produce an element having high photoelectric conversion efficiency. Moreover, the coating method is excellent also in production velocity.

Although there is no restriction in the coating method to be used, examples of the methods are cited as: a spin coat method, a cast method from a solution, a dip coat method, a blade coat method, a wire bar coat method, a gravure coat method and a spray coat method. In addition, it can be used the pattering method using printing methods such as: an ink-jet method, a screen printing method, a typographic printing method, an intaglio printing method, an offset printing method and a flexography method.

After coating, it is preferable to heat the film in order to remove the residual solvent, water and a gas, as well as to improve the mobility and to make the absorption in the longer wavelength by crystallization of a semiconductor material. When an annealing treatment is carried out at a prescribed temperature during a manufacturing process, aggregation or crystallization is microscopically promoted and a suitable phase separation structure can be made in a bulk heterojunction layer. As a result, the carrier mobility of a bulk heterojunction layer can be improved and high efficiency can be obtained.

The photoelectron conversion layer (bulk heterojunction layer) 14 may be a single layer containing a uniform mixture of an electron acceptor and an electron donor. It may be a multiplicity of layers each changing the mixing ratio of an electron acceptor and an electron donor. In this case, such layers may be formed by using aforementioned material

which becomes insoluble after coated.

<Patterning>

In the production of an organic photoelectric conversion element of the present invention, the method to carry out patterning of the power generation layer, the hole transport layer and the electron transport layer is not specifically limited, and a method well known in the art may be appropriately employed.

If the material for coating such as a bulk heterojunction layer or a transport layer is a soluble material, coating via a whole layer coating method such as a die coat method or a dip coat method may be conducted, followed by wiping off unnecessary portion, or direct patterning may be conducted via, for example, an inkjet method or a screen printing method.

In the case of an insoluble material, for example, an electrode material, patterning may be conducted via a method well known in the art, for example, by conducting vacuum evaporation using a mask when the electrode is accumulated under vacuum, or by conduction an etching method of a lift off method. Further, patterning may be conducted by transferring a pattern formed on a different substrate.

## EXAMPLES

Hereafter, the present invention will be described specifically by referring to examples, however, the present invention is not limited to them. In Examples, the terms "parts" and "%" are used. Unless otherwise specifically mentioned, these represent "mass parts" and "mass%", respectively.

Example 1

<<Preparation of gas barrier film>>

[Preparation of Gas barrier film 1]

Gas barrier film 1 was prepared according to the manufacture line of the gas barrier film shown in FIG. 1a, in which a drying process and a modification process are separated.

(Preparation of substrate)

As a thermoplastic resin substrate, employed was a polyethylene terephthalate film having a thickness of 125 μm, both surfaces of which had been subjected to an easy adhesive treatment (super-low heat shrinkage PET Q83, produced by Teijin Dupont Films Japan Ltd.).

(Preparation of bleedout preventing layer)

On one surface of the above substrate, a UV curable organic/inorganic hybrid hard coat material OPSTAR Z7535 produced by JSR Corp. was applied using a wire bar so that the thickness after dried was 4 μm, followed by conducting a hardening treatment under a hardening condition: 1.0 J/cm$^2$, in air, and using a high-pressure mercury lamp, and a drying condition: 80 °C for 3 minutes. Thus, a bleedout preventing layer was formed.

(Preparation of smooth layer)

Subsequently, on the other surface of the above bleedout preventing layer formed surface of the above substrate, a UV curable organic/inorganic hybrid hard coat material OPSTAR Z7501 produced by JSR Corp. was applied using a wire bar so that the thickness after dried was 4 μm, the coated layer was dried under a drying condition of 80 °C for 3 minutes, and, then, a hardening treatment was conducted in air using a high-pressure mercury lamp under a hardening condition of 1.0 J/cm$^2$. Thus, a smooth layer was formed.

The average roughness Ra of formed flat layer was measured according the following method, and found to be 16 nm.

The surface roughness Ra was calculated from the uneven cross-sectional curve obtained by continuously measuring with a detector having a stylus with an extremely small tip radius using an AFM (an atomic force microscope). The obtained surface roughness is an average roughness with respect to a minute roughness amplitude determined by measuring the zone of 30 μm in the measuring direction many times using a stylus.

(Formation of polysilazane layer)

Subsequently, a substrate on which a flat later and a bleedout preventing layer are respectively formed on each surface was cut into a 10 cm square, and on the flat layer on the flat layer formed surface, a polysilazane layer was formed by coating according to the following method.

A 20% by mass dibutyl ether solution of peroxypolysilazane (AQUAMICA NN 120-20, produced by AZ ELECTRONIC MATERIALS) was used. This solution was further diluted with dibutyl ether to adjust the concentration of perhydropolysilazane, and then the resulting solution was applied on the smooth layer via a die coat method. Thus, a polysilazane layer was formed.

(Drying process of polysilazane layer)

Subsequently, a drying treatment at 80 °C for 3 minutes was conducted as a drying process to form a perhydropolysilazme-containing layer (namely, a polysilazane layer) having a dry thickness of 170 nm. At this time, the polysilazane-containing layer was not completely solidified.

(Modification treatment)

Next, the above specimen in which a polysilazane-containing layer was formed was subjected to a modification treatment according to the method described below, thus, comparative Gas barrier film 1 was prepared.

<Adjusting oxygen concentration during modification process>

In the modification treatment process, nitrogen gas flow and oxygen gas flow introduced into a VUV light irradiation process were measured using a flow meter, and the oxygen concentration was adjusted to be within the range of 0.9% to 1.1 % via the flow ratio of nitrogen gas/oxygen gas introduced into the process.

<VUV light irradiation>

At position B at which vacuum ultraviolet light irradiating device 7 was installed in drying process 6 as illustrated in FIG. 1a, the above sample in which drying the polysilazane layer was completed was subjected to VUV light irradiation as follows. Employing a stage-movable Xenon excimer irradiation device MODEL: MECL-M-1-200 (a wavelength of 172 nm) manufactured by M.D. Excimer Inc., the above sample was reciprocation-transported at a stage-moving speed of 10 mm/sec while the distance between the lamp and the above-described sample was set at 1 mm, and sample temperature was kept at 80 °C. After the sample was irradiated with VUV light during 5 round trips in total, the sample was removed therefrom to obtain comparative Gas barrier film 1.

[Preparation of Gas barrier film 2]

Gas barrier film 2 was prepared according to the gas barrier film manufacturing line of the present invention as shown in FIG. 1b, in which the modification process was provided in the drying process.

In the preparation of above Gas barrier film 1, the drying process of the polysilazane layer was not independently used, but the drying treatment and the modification treatment were simultaneously conducted, which will be described below, to conduct a modification treatment. Thus, Gas barrier film 2 was prepared.

At position D at which vacuum ultraviolet light irradiating device 7 was installed in drying process 6 as illustrated in FIG. 1b, the wet sample provided with a polysilazane layer was dried by blowing with warm wind of 40 °C in the first half portion of the drying process, and, in the second half portion of the process, the sample was subjected to VUV light irradiation as follows. Employing a stage-movable Xenon excimer irradiation device MODEL: MECL-M-1-200 (a wavelength of 172 nm) manufactured by M.D. Excimer Inc., the above sample was reciprocation-transported at a stage-moving speed of 10 mm/sec while the distance between the lamp and the above-described sample was set at 1 mm, and sample temperature was kept at 40 °C. After the sample was irradiated with VUV light during 5 round trips in total, the sample was removed therefrom to obtain comparative Gas barrier film 2. In the preparation of Gas barrier film 2, the irradiation with VUV light was conducted when the residual solvent amount became 60%, and completed when the residual solvent amount of the polysilazane layer became 25%.

[Preparation of Gas barrier film 3]

Gas barrier film 3 was prepared in the same manner as the preparation of above Gas barrier film 2, except that

the temperature of warm wind in the drying+modifying process was changed to 68 °C.

[Preparation of Gas barrier film 4]

Gas barrier film 4 was prepared in the same manner as the preparation of above Gas barrier film 2, except that the temperature of warm wind in the drying+modifying process was changed to 70 °C.

[Preparation of Gas barrier film 5]

Gas barrier film 5 was prepared in the same manner as the preparation of above Gas barrier film 2, except that the temperature of warm wind in the drying+modifying process was changed to 80 °C.

[Preparation of Gas barrier film 6]

Gas barrier film 6 was prepared in the same manner as the preparation of above Gas barrier film 2, except that the temperature of warm wind in the drying+modifying process was changed to 120 °C.

[Preparation of Gas barrier film 7]

Gas barrier film 7 was prepared in the same manner as the preparation of above Gas barrier film 2, except that the temperature of warm wind in the drying+modifying process was changed to 200 °C.

[Preparation of Gas barrier film 8]

Gas barrier film 8 was prepared in the same manner as the preparation of above Gas barrier film 2, except that the temperature of warm wind in the drying+modifying process was changed to 220 °C.

[Preparation of Gas banier film 9]

Gas barrier film 9 was prepared in the same manner as the preparation of above Gas barrier film 4, except that, as an irradiation condition with VUV light, the irradiation with VUV light was conducted when the residual solvent amount of the polysilazane layer became 90%, and completed when the residual solvent amount became 60%.

[Preparation of Gas barrier film 10]

Gas barrier film 10 was prepared in the same manner as the preparation of above Gas barrier film 4, except that, as an irradiation condition with VUV light, the irradiation with VUV light was conducted when the residual solvent amount of the polysilazane layer became 70%, and completed when the residual solvent amount became 30%.

[Preparation of Gas barrier film 11]

Gas barrier film 11 was prepared in the same manner as the preparation of above Gas barrier film 4, except that, as an irradiation condition with VUV light, the irradiation with VUV light was conducted when the residual solvent amount of the polysilazane layer became 60%, and completed when the residual solvent amount became 10%.

[Preparation of Gas barrier film 12]

Gas barrier film 12 was prepared in the same manner as the preparation of above Gas barrier film 4, except that, as an irradiation condition with VUV light, the irradiation with VUV light was conducted when the residual solvent amount of the polysilazane layer became 25%, and completed when the residual solvent amount became 0%.

<<Evaluation of gas barrier film>>

[Evaluation of gas barrier property 1: Measurement of water vapor permeability just after preparation]

The water vapor permeability of each gas barrier film was measured according to the following method to evaluate the gas barrier property.

(Equipment)

Vacuum evaporation apparatus: Vacuum evaporation apparatus JEE-400 produced by JEOL Co., Ltd.

Constant temperature -constant humidity oven: Humidic Chamber IG47M produced by Yamato Scientific, Co., Ltd.

(Raw material)

Metal corrosive by reacting with water: Calcium (granular)
Metal exhibiting no water vapor permeation: Aluminum (φ 3 - 5 mm, granular)

(Preparation of cell for evaluation of water vapor barrier property)

Metallic calcium was vacuum evaporated using a vacuum evaporation apparatus (Vacuum evaporation apparatus JEE-400 produced by JEOL Co., Ltd.) on the barrier film sample, while masking other than the portions to be evaporated (9 portions of the size 12 mm × 12 mm). After that, the mask was removed while the vacuum was maintained, and aluminum was evaporated from another metal evaporation source onto entire surface of one side. After the aluminum sealing, the vacuum state was released, and, promptly, the aluminum sealed surface was faced with a quartz glass plate having a thickness of 0.2 mm through a UV curable resin for sealing (produced by Nagase ChemteX Corporation) under a dried nitrogen atmosphere, followed by being irradiated with ultraviolet light The evaluation cells were thus prepared.

(Measurement)

The obtained samples were stored under a high temperature-high humidity condition of 60 °C and 90%RH, and the amount of water permeated into the cell was calculated from the amount of corrosion of metallic calcium according to the method described in JP-A No. 2005-283561. The gas barrier property was evaluated according to the following criteria. 5: The water vapor permeability is less than $5 \times 10^{-4}$ g/m$^2$/day.

4: The water vapor permeability is $5 \times 10^{-4}$ g/m$^2$/day or more but less than $5 \times 10^{-3}$ g/m$^2$/day.
3: The water vapor permeability is $5 \times 10^{-3}$ g /m$^2$/day or more but less than $5 \times 10^{-2}$ g /m$^2$/day.
2: The water vapor permeability is $5 \times 10^{-2}$ g /m$^2$/day or more but less than $5 \times 10^{-1}$ g/m$^2$/day.
1: The water vapor permeability is $5 \times 10^{-1}$ g /m$^2$/day or more.

[Evaluation of gas barrier property 2: Measurement of water vapor permeability after enforced degradation (temporal stability)]

Each gas barrier film prepared as aforementioned was continuously stored for 7 days in constant temperature -constant humidity oven kept at 85 °C: (Humidic Chamber IG47M produced by Yamato Scientific, Co., Ltd.), and, after that, the water vapor permeability was measured according to the same method as described above to evaluate the gas barrier property after the enforced degradation according to the same evaluation criteria.

(Measurement of surface smoothness)

The surface smoothness Rt of each gas barrier film prepared as aforementioned was calculated from the uneven cross-sectional curve obtained by continuously measuring with a detector having a stylus with an extremely small tip radius using an AFM (an atomic force microscope). Using a stylus having an extremely small tip radius, a zone of 30 μm in the measuring direction was measured many times, and an average roughness was obtained from the amplitude of the minute roughness, which was then designated as surface smoothness Rt The variation ofRt of the gas barrier layer surface was ascribed to the minute unevenness as the result of the energy received in the modification treatment. The surface smoothness was evaluated by ranking the obtained surface smoothness Rt according to the following criteria.

5: Surface smoothness Rt is less than 5 nm.
4: Surface smoothness Rt is 5 nm or more but less than 10 nm.
3: Surface smoothness Rt is 10 nm or more but less than 20 nm.
2: Surface smoothness Rt is 20 nm or more but less than 30 nm.

1: Surface smoothness Rt is 30 nm or more.

(Evaluation of bending resistance)

Each of the gas barrier films was repeatedly bent 100 times at an angle of 180 ° to form a curvature radius of 10 mm, and then the water vapor permeability was measured according to the same method as described above. The bending resistance was evaluated according to the same ranking criteria.

The obtained results were listed in Table 1.

Table 1

| Gas barrier film No. | Single drying process | | Drying process + Modification process | | | Evaluation results | | | | Remarks |
|---|---|---|---|---|---|---|---|---|---|---|
| | Temperature (°C) | Drying time (min.) | Vacuum UV irradiation condition | | | Evaluation of gas barrier property | | Surface smoothness | Bending resistance | |
| | | | Processing temperature | Initial drying ratio (%) | Final drying ratio (%) | Just after preparation | After enforced degradation | | | |
| 1 | 80 | 3 | 80 (**) | - | - | 2 | 1 | 3 | 1 | Comparative |
| 2 | - | - | 40 | 60 | 25 | 3 | 3 | 4 | 3 | Inventive |
| 3 | - | - | 68 | 60 | 25 | 3 | 3 | 4 | 3 | Inventive |
| 4 | - | - | 70 | 60 | 25 | 4 | 4 | 4 | 4 | Inventive |
| 5 | - | - | 80 | 60 | 25 | 5 | 4 | 5 | 4 | Inventive |
| 6 | - | - | 120 | 60 | 25 | 5 | 5 | 5 | 5 | Inventive |
| 7 | - | - | 200 | 60 | 25 | 5 | 4 | 5 | 5 | Inventive |
| 8 | - | - | 220 | 60 | 25 | 4 | 4 | 4 | 4 | Inventive |
| 9 | - | - | 70 | 90 | 60 | 3 | 3 | 3 | 3 | Inventive |
| 10 | - | - | 70 | 70 | 30 | 3 | 3 | 4 | 3 | Inventive |
| 11 | - | - | 70 | 60 | 10 | 4 | 4 | 4 | 4 | Inventive |
| 12 | - | - | 70 | 35 | 0 | 3 | 3 | 3 | 3 | Inventive |

**: modification process

As is clear from the results shown in Table 1, the gas barrier film of the present invention is superior to comparative Gas barrier film 1 in terms of the gas barrier property just after preparation, the gas banier property after an enforced degradation (temporal stability), the surface smoothness and the bending resistance.

Example 2

<<Preparation of organic photoelectric conversion element>>

Employing each of the gas barrier films prepared in Example 1, Organic photoelectric conversion elements 1 to 12 were prepared.

On each of the gas barrier films, a first electrode was formed by patterning an indium•tin oxide (ITO) transparent conductive film accumulated to a thickness of 150 nm (of which sheet resistance was 10 Ω/□) to a width of 2 mm via a commonly used photolithographic technique and a wet etching technique. The patterned first electrode was washed via sequential steps of ultrasonic washing using a surfactant and ultra pure water and ultrasonic washing using ultra pure water, followed by drying under a nitrogen flow, and, finally, cleaned via ultraviolet/ozone cleaning.

On this transparent substrate, an electroconductive polymer Baytron. P4083 (produced by Starck Vitec, Co.) was applied so that the thickness was 30 nm, and then dried. Subsequently, the layer was subjected to a heat treatment at 150 °C for 30 minutes to form a positive hole transport layer.

After that, each substrate was carried into a nitrogen chamber and preparation was carried out under a nitrogen atmosphere.

First, the above mentioned substrate was heat treated for 10 minutes at 150 °C under a nitrogen atmosphere. Then, a liquid was prepared by mixing, in chlorobenzene, 3.0% by mass of 1:0.8 mixture of P3HT (produced by Plectronics, Inc.: regioregular-poly-3-hexylthiophene) and PCBM (produced by Frontier Carbon Corporation: 6,6 -phenyl-$C_{61}$-butyric acid methyl ester), and applied onto the resulting substrate, while filtering, so that the thickness was 100 nm. The product was dried by leaving at an ambient temperature. Subsequently, a heat treatment at 150 °C for 15 minutes was conducted to prepare a photoelectric conversion layer.

Next, the substrate on which the aforementioned series of function layers were formed was moved into the chamber of a vacuum evaporation apparatus, and, after the inside of the vacuum evaporation apparatus was evacuated to $1 \times 10^{-4}$ Pa or less, lithium fluoride was accumulated to a thickness of 0.6 nm at an evaporation rate of 0.01 nm/sec, and, subsequently, metallic Al was accumulated to a thickness of 100 nm at an evaporation rate of 0.2 nm/sec through a shadow mask having a width of 2 mm (vacuum evaporation was conducted by orthogonally crossing the masks so that the photo receiving portion became $2 \times 2$ mm), whereby a second electrode was formed. Obtained organic photoelectric conversion element was transferred to a nitrogen chamber, and sealing was conducted using a sealing cap and a UV curable resin. Thus, each organic photoelectric conversion element having a $2 \times 2$ mm size photo receiving portion was prepared.

<<Sealing of organic photoelectric conversion element>>

Under a circumstance purged by a nitrogen gas (an inert gas), an epoxy-photocurable adhesive was applied as a sealant on two sheets of each gas barrier film on the surface on which the gas barrier layer was formed to prepare each sample. Each of the above prepared sample applied with the above adhesive was adhered with an organic photoelectric conversion element corresponding to each sample obtained as above (namely, an organic photoelectric conversion element having the same gas barrier film was adhered), while each photoelectric conversion element was brought in close contact with the adhesive coated surface by sandwiching with the adhesive coated surface. Then the adhesive was irradiated with UV light from one substrate side to be hardened. Thus, Organic photoelectric conversion elements 1 to 12 were finally prepared.

<<Evaluation of durability: Evaluation of energy conversion efficiency>>

Obtained organic photoelectric conversion element was irradiated with light of 100 mW/$cm^2$ from a solar simulator (AM 1.5G filter). By evaluating an I-V property while placing a mask having an effective area of 4.0 $mm^2$ on the photo receiving portion, a short circuit current density Jsc (mA/$cm^2$), an open circuit voltage Voc (V) and a fill factor FF (%) were determined to evaluate the energy conversion efficiency PCE (%) calculated according to following Formula 1 for each of the four photo receiving portions formed on the same element. Then, an average of the above four energy conversion efficiencies was obtained.

$$\text{Formula 1} \qquad PCE\,(\%) = [Jsc\,(mA/cm^2) \times Voc\,(V) \times FF\,(\%)] / 100\,mW/cm^2.$$

After the initial energy conversion efficiency PCE1 (%) was measured, an enforced degradation test in which the element was stored at 60 °C under 90%RH for 1000 hours was conducted. Then, the energy conversion efficiency after the enforced degradation test PCE2 (%) was measured via the same method as described above. A changing ratio of the energy conversion efficiency was determined using following Formula 2, and then evaluated according to the following cariteria.

$$\text{Formula 2} \qquad \text{Stability of energy conversion efficiency} = (\text{energy conversion efficiency after enforced degradation test PCE2 (\%)} / \text{initial energy conversion efficiency PCE1 (\%)}) \times 100$$

5: The energy conversion efficiency is 90% or more.
4: The energy conversion efficiency is 70% or more, but less than 90%.
3: The energy conversion efficiency is 40% or more, but less than 70%.
2: The energy conversion efficiency is 20% or more, but less than 40%.
1: The energy conversion efficiency is less than 20%.

Obtained results were listed in Table 2.

Table 2

| Organic photoelectric conversion element No. | Gas barrier film No. | Evaluation of durability | Remarks |
|---|---|---|---|
| 1 | 1 | 3 | Comparative |
| 2 | 2 | 4 | Inventive |
| 3 | 3 | 4 | Inventive |
| 4 | 4 | 5 | Inventive |
| 5 | 5 | 5 | Inventive |
| 6 | 6 | 5 | Inventive |
| 7 | 7 | 5 | Inventive |
| 8 | 8 | 4 | Inventive |
| 9 | 9 | 4 | Inventive |
| 10 | 10 | 4 | Inventive |
| 11 | 11 | 5 | Inventive |
| 12 | 12 | 4 | Inventive |

As is clear from the results shown in Table 2, the organic photoelectric conversion element of the present invention can maintain an excellent energy conversion efficiency, even after being stored under an extreme circumstance for a long time, when compared with a comparative example.

## DESCRIPTION OF NUMERALS

1. Supply roll
2. Support roll
3. Substrate
4. Polysilazane layer coating liquid tank
5. Coater
6. Drying process

(continued)

| | |
|---|---|
| 7. | Vacuum ultraviolet light irradiation device |
| 8. | Winding roll |
| 9. | Drying process + modification process |

## Claims

1. A method of manufacturing a gas barrier film comprising the steps of:

    applying a coating liquid comprising polysilazane on a substrate to form a coated layer; and
    irradiating a coated layer side of the substrate with vacuum ultraviolet light to form a gas barrier layer, wherein the coated layer is irradiated with the vacuum ultraviolet light while drying a solvent contained in the coated layer.

2. The method of manufacturing the gas barrier film of claim 1, wherein the vacuum ultraviolet light is an irradiation light from a xenon excimer lamp.

3. The method of manufacturing the gas barrier film of claim 1 or 2, wherein an environment temperature when the coated layer is irradiated with the vacuum ultraviolet light is 70 °C or more, but 200 °C or less.

4. The method of manufacturing the gas barrier film of any one of claims 1 to 3, wherein the coated layer is irradiated with the vacuum ultraviolet light under a condition in which a residual amount of the solvent in the coated layer is 60% by mass or less, but 10% by mass or more.

5. An organic photoelectric conversion element comprising the gas barrier film manufactured by the method of manufacturing the gas barrier film of any one of claims 1 to 4.

FIG. 1a

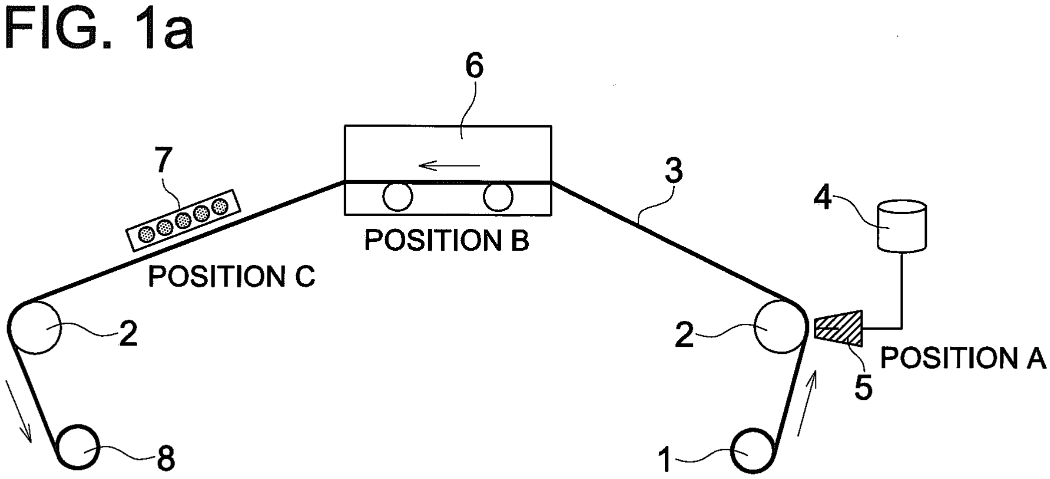


FIG. 1b

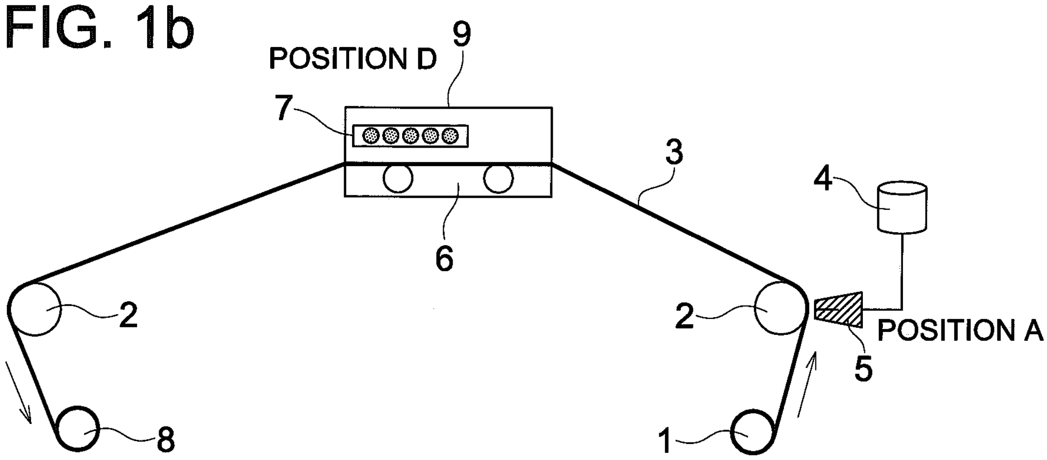


FIG. 2

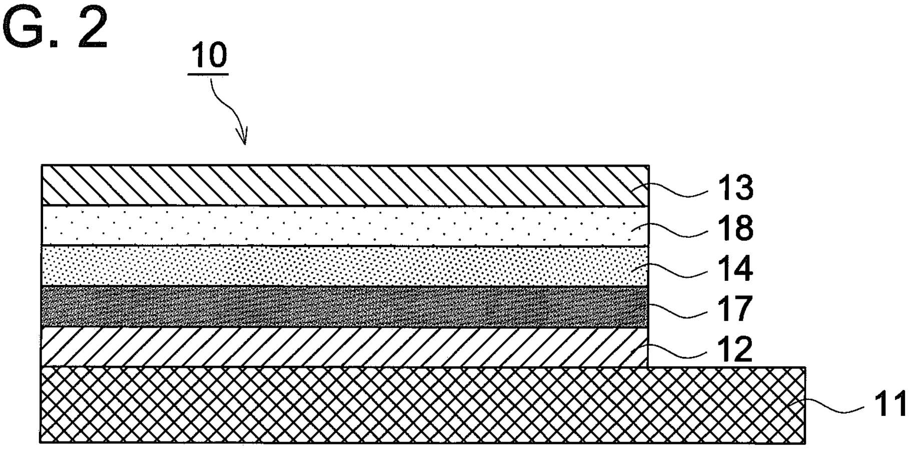

FIG. 3

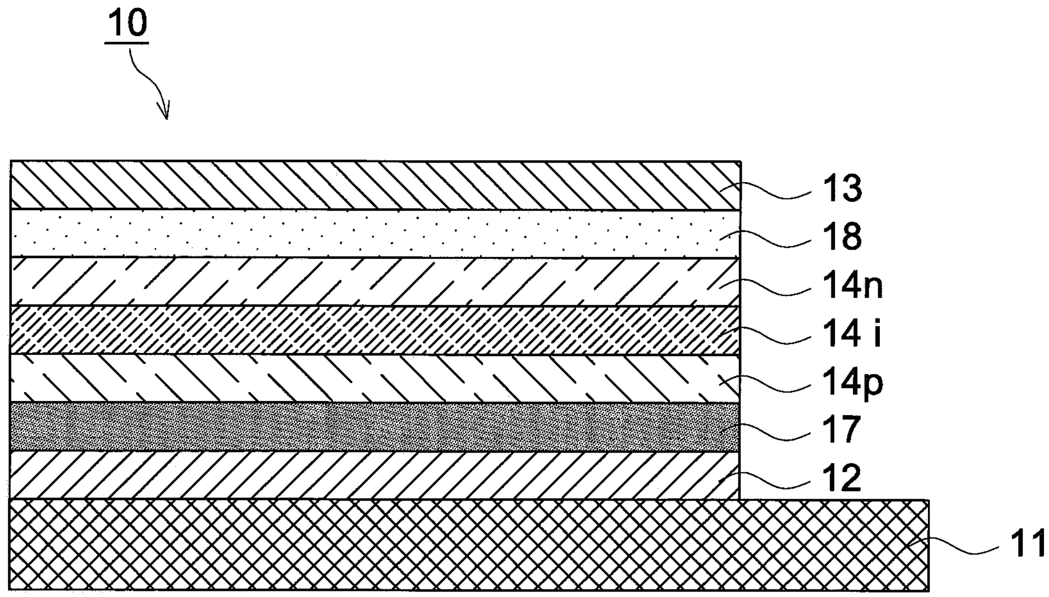


FIG. 4

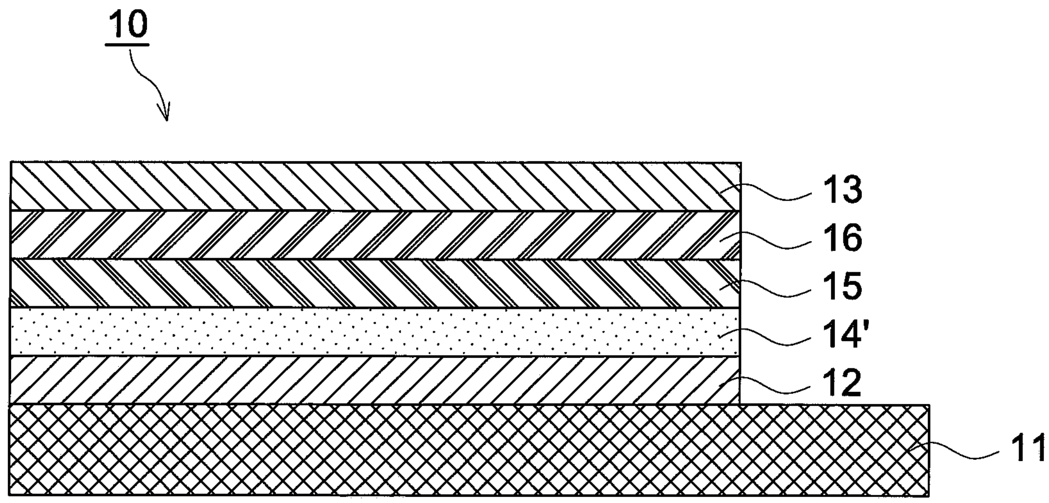

**INTERNATIONAL SEARCH REPORT**

International application No.
PCT/JP2011/068556

A. CLASSIFICATION OF SUBJECT MATTER
*B05D3/06*(2006.01)i, *B05D5/00*(2006.01)i, *B32B9/00*(2006.01)i, *B65D65/40* (2006.01)i, *H01L51/50*(2006.01)i, *H05B33/02*(2006.01)i, *H05B33/04*(2006.01)i, *H05B33/10*(2006.01)i
According to International Patent Classification (IPC) or to both national classification and IPC

B. FIELDS SEARCHED

Minimum documentation searched (classification system followed by classification symbols)
B05D1/00-7/26, B32B1/00-43/00, C08J7/04-7/06, B65D65/00-65/46, H05B33/00-33/28, H01L51/50-51/56

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 10-279362 A (Tonen Corp.),<br>20 October 1998 (20.10.1998),<br>claim 1; paragraphs [0044] to [0046], [0056] to [0057], [0060], [0093]<br>(Family: none) | 1-2<br>5<br>3-4 |
| X<br>Y<br>A | JP 2009-255040 A (Kyodo Printing Co., Ltd.),<br>05 November 2009 (05.11.2009),<br>claim 1; paragraphs [0002], [0031]<br>(Family: none) | 5<br>5<br>1-4 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 November, 2011 (04.11.11) | 15 November, 2011 (15.11.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009503157 A
- JP 2009255040 A
- JP 8112879 A
- JP 5238827 A
- JP 6122852 A
- JP 6240208 A
- JP 6299118 A
- JP 6306329 A
- JP 7196986 A
- WO 0316599 A
- WO 0328125 A
- US 6690029 B
- JP 2004107216 A
- US 2003136964 A
- WO 2008000664 A
- JP 2008016834 A
- JP 2006199674 A
- JP 2008130889 A
- US 7329709 B
- WO 2006019270 A
- JP 5271166 A
- JP 2006233252 A
- JP 2002266007 A
- JP 2004149871 A
- JP 2005283561 A


### Non-patent literature cited in the description


- *J. Amer. Chem. Soc,* vol. 127 (14), 4986
- *J. Amer. Chem. Soc.,* vol. 123, 9482
- *J. Amer. Chem. Soc.,* 2008, vol. 130 (9), 2706
- Technical Digest of the International PVSEC-17. *Fukuoka,* 2007, 1225
- *Nature Material,* 2006, vol. 5, 328
- *Adv. Mat.,* 2007, 4160
- *Nature Material,* 2007, vol. 6, 497
- *Adv. Mater.,* 2008, vol. 20, 2116
- *Adv. Mater.,* 2002, vol. 14, 833-837
- *Chem. Mater.,* 2002, vol. 14, 4736-4745